# FASCICULE DE BREVET EUROPEEN

(11) **EP 3 346 597 B1**
(45) Date de publication et mention de la délivrance du brevet: **17.04.2019**
(21) Numéro de dépôt: 18150659.3
(22) Date de dépôt: 08.01.2018
(51) Int. Cl.: H02M 7/219, H02M 7/48, H02M 1/00, H02M 1/42, H02M 7/162, H02M 7/5388, H03K 3/3562, H03K 17/06, H03K 17/30, H03K 17/74

(54) **CONVERTISSEUR DE PUISSANCE AC-DC**
WECHSELSTROM-GLEICHSTROM-WANDLER
AC-DC POWER CONVERTER

(30) Priorité: 10.01.2017 FR 1750209
(43) Date de publication de la demande: 11.07.2018
(73) Titulaire: Commissariat à l'Energie Atomique et aux Energies Alternatives, 75015 Paris (FR)
(72) Inventeur: STERNA, Léo, 38100 Grenoble (FR); LADHARI, Othman, 38130 Echirolles (FR); FERRIEUX, Jean-Paul, 38031 Grenoble Cedex 1 (FR); FREY, David, 38031 Grenoble Cedex 1 (FR); JEANNIN, Pierre-Olivier, 38031 Grenoble Cedex 1 (FR)
(74) Mandataire: Cabinet Beaumont

(56) Documents cités:
- GUO SUXUAN ET AL: "Operation principles of bidirectional isolated AC/DC converter with natural clamping soft switching scheme", IECON 2014 - 40TH ANNUAL CONFERENCE OF THE IEEE INDUSTRIAL ELECTRONICS SOCIETY, IEEE, 29 octobre 2014 (2014-10-29), pages 4866-4872, XP032739726, DOI: 10.1109/IECON.2014.7049238
- NORRGA S ED - INSTITUTE OF ELECTRICAL AND ELECTRONICS ENGINEERS: "A soft-switched bi-directional isolated AC/DC converter for AC-fed railway propulsion applications", PROCEEDINGS OF THE 14TH. INTERNATIONAL SYMPOSIUM ON POWER SEMICONDUCTOR DEVICES & ICS. ISPSD'02. SANTA FE, NM, JUNE 4 - 7, 2002; [INTERNATIONAL SYMPOSIUM ON POWER SEMICONDUCTOR DEVICES & IC'S], NEW YORK, NY : IEEE, US, 4 juin 2002 (2002-06-04), pages 433-438, XP010602949, ISBN: 978-0-7803-7318-1

## Description

### Domaine

La présente demande concerne le domaine des convertisseurs de puissance, et vise plus particulièrement un convertisseur AC-DC, c'est-à-dire un convertisseur adapté à convertir une tension alternative en une tension continue.

### Exposé de l'art antérieur

Un convertisseur AC-DC comprend classiquement un étage de redressement de la tension alternative appliquée à son entrée, comportant une ou plusieurs diodes, suivi d'un étage de filtrage passe bas de la tension alternative redressée délivrée par l'étage de redressement, suivi d'un étage de conversion DC-DC (continu-continu) de la tension continue délivrée par l'étage de filtrage passe-bas, typiquement un étage de conversion à découpage comportant un ou plusieurs interrupteurs commandés et un transformateur d'isolement.

Un inconvénient des convertisseurs de ce type réside dans leur coût et leur encombrement relativement importants, résultant du nombre élevé de composants qu'ils comprennent et de la taille de ces composants.

En particulier, l'étage de filtrage passe-bas comprend classiquement un condensateur de grande taille, typiquement un condensateur de plusieurs dizaines de microfarads et de plusieurs centaines de volts pour un convertisseur destiné à recevoir sur son entrée alternative une tension AC de 220 V, par exemple la tension secteur.

En outre, pour limiter les pertes en commutation dans l'étage de conversion DC-DC à découpage, la fréquence de fonctionnement de l'étage de conversion (ou fréquence de découpage) est généralement limitée à quelques centaines de kHz, ce qui restreint les possibilités de miniaturisation de l'étage de conversion DC-DC, et en particulier du transformateur d'isolement.

Un autre inconvénient des convertisseurs de ce type est que la présence de l'étage de redressement à diodes limite significativement le rendement du convertisseur.

Par ailleurs, dans certaines applications dans lesquelles le convertisseur est utilisé pour alimenter une charge DC active, par exemple une batterie, il existe un besoin pour un convertisseur réversible, c'est-à-dire apte non seulement à convertir la tension d'entrée alternative en une tension de sortie continue pour alimenter la charge (typiquement pour charger une batterie à partir d'une tension alternative), mais aussi à convertir une tension continue délivrée par la charge en une tension alternative fournie sur les bornes d'entrée alternative du convertisseur (typiquement pour réinjecter sur le réseau alternatif de l'énergie électrique puisée dans la batterie). De par leur architecture, et en particulier du fait de la présence de l'étage de redressement à diodes et de l'étage de filtrage passe-bas, les convertisseurs du type décrit ci-dessus ne permettent pas d'assurer une telle réversibilité.

Le brevet US6424548 décrit un convertisseur AC-DC à découpage à conversion dite directe, c'est-à-dire ne comportant pas d'étage de redressement à diodes ni d'étage de filtrage passe-bas en amont de l'étage de conversion à découpage. Plus particulièrement, ce convertisseur comprend quatre interrupteurs bidirectionnels formant un premier pont en H commandé, suivi d'un transformateur d'isolement comportant un enroulement primaire et un enroulement secondaire couplés magnétiquement, suivi de quatre interrupteurs quasi-bidirectionnels formant un deuxième pont en H commandé. L'entrée du premier pont en H reçoit directement la tension alternative à convertir, l'enroulement primaire du transformateur est connecté entre les bornes de sortie du premier pont en H, l'enroulement secondaire du transformateur est connecté entre les bornes d'entrée du deuxième pont en H, et la charge DC à alimenter est connectée entre les bornes de sortie du deuxième pont en H.

Un avantage de ce convertisseur est qu'il ne comporte pas d'étage de redressement à diodes ni d'étage de filtrage passe bas en amont de l'étage de conversion à découpage, ce qui permet de réduire le coût et l'encombrement et d'améliorer le rendement par rapport aux solutions traditionnelles. De plus, ce convertisseur est réversible.

Toutefois, comme dans les convertisseurs traditionnels, les pertes en commutation dans l'étage de conversion à découpage empêchent en pratique d'augmenter la fréquence de commutation des interrupteurs au-delà de quelques centaines de kHz, ce qui restreint les possibilités de miniaturisation du système, et en particulier du transformateur d'isolement.

Il serait souhaitable de pouvoir disposer d'un convertisseur AC-DC palliant tout ou partie des inconvénients susmentionnés des convertisseurs existants.

Les documents GUO SUXUAN ET AL: "Opération principles of bidirectional isolated AC/DC converter with natural clamping soft switching scheme" et NORRGA S ED - INSTITUTE OF ELECTRICAL AND ELECTRONICS ENGINEERS: "A soft-switched bi-directional isolated AC/DC converter for AC-fed railway propulsion applications" font partie de l'état de l'art de la présente demande.

### Résumé

Ainsi, un mode de réalisation prévoit un circuit de conversion d'une tension alternative en une tension continue, comportant :
quatre premiers interrupteurs bidirectionnels formant un premier pont en H, des premier et deuxième noeuds d'entrée du pont étant reliés respectivement à des premier et deuxième noeuds d'application de la tension alternative ;
un transformateur comportant un enroulement primaire et un enroulement secondaire couplés magnétiquement, des première et deuxième extrémités de l'enroulement primaire étant reliées respectivement à des premier et deuxième noeuds de sortie du premier pont ;
une première inductance connectée en série avec le premier pont entre le premier noeud d'entrée du pont et le premier noeud d'application de la tension alternative ;
une deuxième inductance connectée en série avec le premier pont, entre le premier noeud de sortie du pont et la première extrémité de l'enroulement primaire ; et
un circuit de commande adapté à commander le premier pont alternativement dans une première configuration dans laquelle les interrupteurs d'une première diagonale du pont sont fermés et les interrupteurs d'une deuxième diagonale du pont sont ouverts, et dans une deuxième configuration dans laquelle les interrupteurs de la première diagonale sont ouverts et les interrupteurs de la deuxième diagonale sont fermés,
le circuit de commande étant adapté, lors d'une phase de transition entre les première et deuxième configurations, à, successivement :
   fermer un premier interrupteur de la deuxième diagonale, tout en maintenant le premier interrupteur de la première diagonale et le deuxième interrupteur de la première diagonale fermés et le deuxième interrupteur de la deuxième diagonale ouvert ;
   ouvrir un premier interrupteur de la première diagonale lorsque le courant traversant cet interrupteur s'annule ;
   fermer le deuxième interrupteur de la deuxième diagonale, tout en maintenant le premier interrupteur de la deuxième diagonale et le deuxième interrupteur de la première diagonale fermés et le premier interrupteur de la première diagonale ouvert ; et
   ouvrir le deuxième interrupteur de la première diagonale lorsque le courant traversant cet interrupteur s'annule.

Selon un mode de réalisation, le circuit de conversion comprend en outre quatre deuxièmes interrupteurs formant un deuxième pont en H, des premier et deuxième noeuds d'entrée du deuxième pont étant reliés respectivement à des première et deuxième extrémités de l'enroulement secondaire du transformateur, et des premier et deuxième noeuds de sortie du deuxième pont étant reliés respectivement à des premier et deuxième noeuds de fourniture de la tension continue.

Selon un mode de réalisation, le circuit de commande est adapté à commander le deuxième pont alternativement dans une première configuration dans laquelle les interrupteurs d'une première diagonale du pont sont fermés et les interrupteurs d'une deuxième diagonale du pont sont ouverts, et dans une deuxième configuration dans laquelle les interrupteurs de la première diagonale sont ouverts et les interrupteurs de la deuxième diagonale sont fermés.

Selon un mode de réalisation, le circuit de commande est configuré pour commuter le premier pont entre ses première et deuxième configurations et pour commuter le deuxième pont entre ses première et deuxième configurations sensiblement à la même fréquence.

Selon un mode de réalisation, le circuit de commande est configuré pour commuter le premier pont entre ses première et deuxième configurations à une fréquence supérieure ou égale à 1 MHz.

Selon un mode de réalisation, chaque premier interrupteur est adapté à être commandé en fermeture par le circuit de commande et à s'ouvrir automatiquement lorsque le courant qui le traverse s'annule.

Selon un mode de réalisation, chaque premier interrupteur est équivalent à une association en anti-série de premier et deuxième transistors MOS connectés par leurs drains, les sources des premier et deuxième transistors formant respectivement les noeuds de conduction de l'interrupteur, et les grilles des premier et deuxième transistors MOS formant des premier et deuxième noeuds de commande de l'interrupteur.

Selon un mode de réalisation, le circuit de commande est configuré pour, lorsqu'il commande la fermeture d'un interrupteur du premier pont, appliquer un signal de commande en fermeture sur la grille de l'un des premier et deuxième transistors de l'interrupteur et maintenir un signal de blocage sur la grille de l'autre transistor.

Selon un mode de réalisation, le circuit de commande est configuré pour, lorsqu'il commande la fermeture d'un interrupteur du premier pont, appliquer un signal de commande en fermeture sur la grille du premier transistor et un signal de blocage sur la grille du deuxième transistor lorsque le courant que doit conduire l'interrupteur est d'une première polarité, et appliquer un signal de commande en fermeture sur la grille du deuxième transistor et un signal de blocage sur la grille du premier transistor lorsque le courant que doit conduire l'interrupteur est d'une deuxième polarité opposée à la première polarité.

Selon un mode de réalisation, les premiers interrupteurs sont des interrupteurs au nitrure de gallium.

Un autre mode de réalisation prévoit un circuit de conversion d'une tension alternative en une tension continue, comportant :
quatre premiers interrupteurs bidirectionnels formant un premier pont en H, des premier et deuxième noeuds d'entrée du pont étant directement reliés respectivement à des premier et deuxième noeuds d'application de la tension alternative ;
un premier condensateur connecté en parallèle du premier pont entre les premier et deuxième noeuds d'entrée du pont ;
un deuxième condensateur connecté en parallèle du premier pont entre des premier et deuxième noeuds de sortie du pont ; et
un circuit de commande adapté à commander le pont alternativement dans une première configuration dans laquelle les interrupteurs d'une première diagonale du pont sont fermés et les interrupteurs d'une deuxième diagonale du pont sont ouverts, et dans une deuxième configuration dans laquelle les interrupteurs de la première diagonale sont ouverts et les interrupteurs de la deuxième diagonale sont fermés,
le circuit de commande étant adapté, lors d'une phase de transition entre les première et deuxième configurations, à, successivement :
   ouvrir les interrupteurs de la première diagonale ; et
   pour chaque interrupteur de la deuxième diagonale, fermer l'interrupteur uniquement lorsque la tension à ses bornes s'annule.

Selon un mode de réalisation, le circuit de conversion comprend en outre quatre condensateurs supplémentaires connectés respectivement aux bornes des quatre premiers interrupteurs.

Selon un mode de réalisation, le circuit de conversion comporte en outre un transformateur comportant un enroulement primaire et un enroulement secondaire couplés magnétiquement, des première et deuxième extrémités de l'enroulement primaire étant reliées respectivement à des premier et deuxième noeuds de sortie du premier pont.

Selon un mode de réalisation, le circuit de conversion comprend en outre quatre deuxièmes interrupteurs formant un deuxième pont en H, des premier et deuxième noeuds d'entrée du deuxième pont étant reliés respectivement à des première et deuxième extrémités de l'enroulement secondaire du transformateur, et des premier et deuxième noeuds de sortie du deuxième pont étant reliés respectivement à des premier et deuxième noeuds de fourniture de la tension continue.

Selon un mode de réalisation, le circuit de commande est adapté à commander le deuxième pont alternativement dans une première configuration dans laquelle les interrupteurs d'une première diagonale du pont sont fermés et les interrupteurs d'une deuxième diagonale du pont sont ouverts, et dans une deuxième configuration dans laquelle les interrupteurs de la première diagonale sont ouverts et les interrupteurs de la deuxième diagonale sont fermés.

Selon un mode de réalisation, le circuit de commande est configuré pour commuter le premier pont entre ses première et deuxième configurations et pour commuter le deuxième pont entre ses première et deuxième configurations sensiblement à la même fréquence.

Selon un mode de réalisation, le circuit de commande est configuré pour commuter le premier pont entre ses première et deuxième configurations à une fréquence supérieure ou égale à 1 MHz.

Selon un mode de réalisation, le circuit de commande comprend, pour chaque premier interrupteur :
un premier circuit adapté à détecter une annulation de la tension aux bornes de l'interrupteur et à fournir un signal logique de sortie correspondant au résultat de cette détection ;
un deuxième circuit adapté à réaliser une opération logique entre le signal fourni par le premier circuit et un signal extérieur de commande de l'interrupteur, et à fournir un signal logique de commande de l'interrupteur correspondant au résultat de cette opération ; et
un troisième circuit adapté à réaliser une adaptation de niveau du signal fourni par le deuxième circuit pour commander en conséquence l'interrupteur.

Selon un mode de réalisation, chaque premier interrupteur est équivalent à une association en anti-série de premier et deuxième transistors MOS connectés par leurs sources, les drains des premier et deuxième transistors formant respectivement les noeuds de conduction de l'interrupteur, et les grilles des premier et deuxième transistors MOS étant connectées à un même noeud de commande de l'interrupteur.

Selon un mode de réalisation, le premier circuit comprend un comparateur de tension, un premier pont diviseur de tension relié entre les noeuds de drain et de source du premier transistor et dont un noeud de sortie est relié à un noeud d'entrée positive du comparateur, et un deuxième pont diviseur de tension relié entre les noeuds de drain et de source du deuxième transistor et dont un noeud de sortie est relié à un noeud d'entrée négative du comparateur.

Selon un mode de réalisation, les premiers interrupteurs sont des interrupteurs au nitrure de gallium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un convertisseur AC-DC selon un premier mode de réalisation ;
la figure 2 est un chronogramme illustrant le fonctionnement du convertisseur de la figure 1 ;
la figure 3 est un schéma bloc illustrant un exemple de réalisation d'un circuit de commande d'un interrupteur du convertisseur de la figure 1 ;
la figure 4 est un schéma plus détaillé d'un exemple de réalisation d'un interrupteur du convertisseur de la figure 1 et du circuit de commande de cet interrupteur ;
la figure 5 est un schéma électrique d'un exemple d'un convertisseur AC-DC selon un deuxième mode de réalisation ;
la figure 6 est un chronogramme illustrant le fonctionnement du convertisseur de la figure 5 ;
les figures 7A et 7B illustrent un exemple de réalisation d'un interrupteur du convertisseur de la figure 5 ;
la figure 8 illustre de façon schématique et partielle un exemple de réalisation d'un circuit de commande du convertisseur de la figure 5 ; et
la figure 9 est un schéma plus détaillé d'un exemple de réalisation du circuit de commande de la figure 8.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les applications qui peuvent être faites des convertisseurs AC-DC décrits n'ont pas été détaillées, les modes de réalisation décrits étant compatibles avec les applications usuelles de convertisseurs AC-DC. De plus, les circuits de commande des interrupteurs des convertisseurs décrits ne sont que partiellement détaillés, la réalisation complète de ces circuits de commande étant à la portée de l'homme du métier à partir des indications de la présente description. Sauf précision contraire, les expressions "approximativement", "sensiblement", et "de l'ordre de" signifient à 10 % près, de préférence à 5 % près. Par ailleurs, on utilise le terme "connecté" pour désigner une liaison électrique directe, sans composant électronique intermédiaire, par exemple au moyen d'une ou plusieurs pistes conductrices ou fils conducteurs, et le terme "couplé" ou le terme "relié", pour désigner une liaison électrique qui peut être directe (signifiant alors "connecté") ou indirecte (c'est-à-dire via un ou plusieurs composants intermédiaires).

### Premier mode de réalisation - structure capacitive

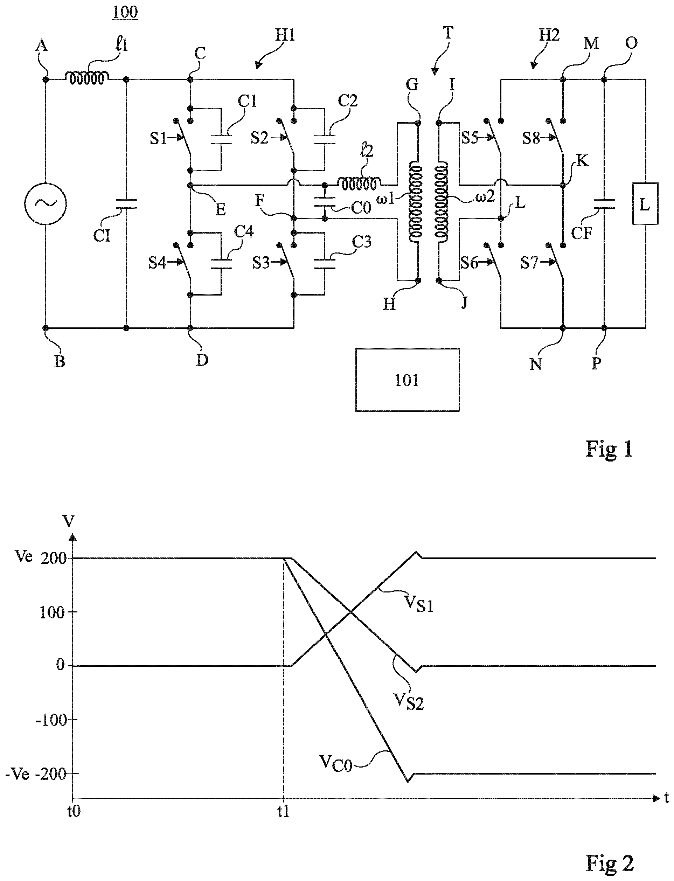

La figure 1 est un schéma électrique d'un exemple d'un convertisseur AC-DC 100 selon un premier mode de réalisation.

Le convertisseur 100 comprend un premier pont en H commandé H1, ou pont primaire, suivi d'un transformateur d'isolement T, suivi d'un deuxième pont en H commandé H2, ou pont secondaire.

Le pont H1 est constitué de quatre interrupteurs commandés bidirectionnels en courant et en tension S1, S2, S3 et S4, par exemple identiques (aux dispersions de fabrication près), comportant chacun deux noeuds de conduction principaux et au moins un noeud de commande. Les interrupteurs S1 et S4 sont reliés en série, par leurs noeuds de conduction, entre des noeuds d'entrée C et D du pont. Les interrupteurs S2 et S3 sont reliés en série, par leurs noeuds de conduction, entre les noeuds C et D, en parallèle de la branche comprenant les interrupteurs S1 et S4. Le point milieu E entre les interrupteurs S1 et S4 définit un premier noeud de sortie du pont, et le point milieu F entre les interrupteurs S2 et S3 définit un deuxième noeud de sortie du pont. Plus particulièrement, dans l'exemple représenté, l'interrupteur S1 a un premier noeud de conduction connecté au noeud C et un deuxième noeud de conduction connecté au noeud E, l'interrupteur S4 a un premier noeud de conduction connecté au noeud E et un deuxième noeud de conduction connecté au noeud D, l'interrupteur S2 a un premier noeud de conduction connecté au noeud C et un deuxième noeud de conduction connecté au noeud F, et l'interrupteur S3 a un premier noeud de conduction connecté au noeud F et un deuxième noeud de conduction connecté au noeud D.

Les noeuds d'entrée C et D du pont H1 sont reliés directement, c'est-à-dire sans étage intermédiaire de redressement à diodes ni de filtrage passe-bas, à des noeuds A et B d'application de la tension alternative d'entrée du convertisseur. Par étage de filtrage passe-bas, on entend ici un étage de filtrage passe-bas de fréquence de coupure environ égale ou inférieure à la fréquence de la tension alternative d'entrée du convertisseur. Des éléments de filtrage passe-bas à plus haute fréquence de coupure peuvent toutefois être prévus, notamment pour filtrer d'éventuels signaux parasites générés lors des commutations des interrupteurs du pont H1. Plus particulièrement, dans cet exemple, le noeud C est relié au noeud A par l'intermédiaire d'une inductance l1, et le noeud D est connecté au noeud B. L'inductance l1 a pour rôle de filtrer d'éventuels pics de tension parasite générés lors des commutations des interrupteurs du pont H1. Dans l'exemple représenté, l'inductance l1 a une première extrémité connectée au noeud A et une deuxième extrémité connectée au noeud C. A titre de variante, l'inductance l1 peut être omise, le noeud C étant alors connecté au noeud A.

Selon un aspect du premier mode de réalisation, le pont primaire H1 est purement capacitif en entrée et en sortie. Plus particulièrement, le convertisseur 100 comprend un condensateur CI dont les électrodes sont connectées respectivement aux noeuds d'entrée C et D du pont H1, et un condensateur CO dont les électrodes sont connectées respectivement aux noeuds de sortie E et F du pont H1. On notera qu'il s'agit là d'un agencement inhabituel. En effet, en électronique de puissance, on prévoit généralement des éléments passifs d'échange d'énergie électrique de natures différentes en entrée et en sortie d'un même pont en H, pour des raisons de respect des règles d'association des sources.

Dans cet exemple, le convertisseur 100 comprend en outre quatre condensateurs C1, C2, C3, C4, par exemple identiques (aux dispersions de fabrication près), reliés respectivement en parallèle des interrupteurs S1, S2, S3, S4 du pont H1. Plus particulièrement, chaque condensateur Ci, avec i entier allant de 1 à 4 a ses électrodes connectées respectivement aux noeuds de conduction de l'interrupteur Si de même indice i.

Le transformateur T comprend un enroulement primaire W1 et un enroulement secondaire W2 couplés magnétiquement.

Les extrémités G et H de l'enroulement primaire W1 sont reliées respectivement aux noeuds E et F de sortie du pont H1. Plus particulièrement, dans l'exemple représenté, l'extrémité G de l'enroulement primaire W1 est reliée au noeud E par l'intermédiaire d'une inductance l2, et l'extrémité H de l'enroulement primaire W1 est connectée au noeud F. L'inductance l2 a pour rôle de filtrer d'éventuels pics de tension parasite. Dans l'exemple représenté, l'inductance l2 a une première extrémité connectée au noeud G et une deuxième extrémité connectée au noeud E. A titre de variante, l'inductance l2 peut être omise, le noeud G étant alors connecté au noeud E.

Le pont H2 est constitué de quatre interrupteurs commandés S5, S6, S7 et S8, par exemple identiques (aux dispersions de fabrication près), comportant chacun deux noeuds de conduction principaux et au moins un noeud de commande. Les interrupteurs S5, S6, S7 et S8 sont par exemple des interrupteurs quasi-bidirectionnels, c'est-à-dire adaptés à laisser circuler du courant dans les deux sens, mais ne permettant un contrôle du courant que dans un sens, c'est-à-dire ne pouvant être commandés à l'état bloqué que lorsqu'une tension d'une polarité déterminée est appliquée entre leurs noeuds de conduction (autrement dit des interrupteurs bidirectionnels en courant mais unidirectionnels en tension) . A titre de variante, les interrupteurs S5, S6, S7, S8 sont des interrupteurs bidirectionnels en courant et en tension. Les interrupteurs S5 et S8 sont reliés en série, par leurs noeuds de conduction, entre des noeuds d'entrée K et L du pont. Les interrupteurs S6 et S7 sont reliés en série, par leurs noeuds de conduction, entre les noeuds K et L, en parallèle de la branche comprenant les interrupteurs S5 et S8. Le point milieu M entre les interrupteurs S5 et S8 définit un premier noeud de sortie du pont, et le point milieu N entre les interrupteurs S6 et S7 définit un deuxième noeud de sortie du pont. Plus particulièrement, dans l'exemple représenté, l'interrupteur S5 a un premier noeud de conduction connecté au noeud L et un deuxième noeud de conduction connecté au noeud M, l'interrupteur S8 a un premier noeud de conduction connecté au noeud M et un deuxième noeud de conduction connecté au noeud K, l'interrupteur S6 a un premier noeud de conduction connecté au noeud L et un deuxième noeud de conduction connecté au noeud N, et l'interrupteur S7 a un premier noeud de conduction connecté au noeud N et un deuxième noeud de conduction connecté au noeud K.

Les noeuds d'entrée K et L du pont H2 sont reliés respectivement aux extrémités I et J de l'enroulement secondaire W2 du transformateur T. Dans l'exemple représenté, l'extrémité I de l'enroulement W2 est connectée au noeud K et l'extrémité J de l'enroulement W2 est connectée au noeud L.

Le convertisseur 100 comprend en outre un condensateur de filtrage de sortie CF, en sortie du pont H2. Dans l'exemple représenté, les électrodes du condensateur CF sont connectées respectivement aux noeuds M et N de sortie du pont H2.

Les noeuds M et N de sortie du pont H2 sont reliés respectivement à des noeuds O et P de fourniture de la tension continue de sortie du convertisseur 100. Dans l'exemple représenté, le noeud M est connecté au noeud O et le noeud N est connecté au noeud P.

Le convertisseur 100 comprend en outre un circuit 101 (non détaillé) de commande des interrupteurs S1, S2, S3, S4, S5, S6, S7 et S8 des ponts H1 et H2.

En fonctionnement, une charge L à alimenter, par exemple une batterie électrique, peut être connectée entre les noeuds O et P de sortie du convertisseur.

Le fonctionnement du convertisseur 100 est le suivant. Le circuit 101 commande le pont primaire H1 alternativement dans une première configuration dans laquelle les interrupteurs S1 et S3, définissant une première diagonale du pont, sont fermés (passants) et les interrupteurs S2 et S4, définissant une deuxième diagonale du pont, sont ouverts (bloqués), et dans une deuxième configuration dans laquelle les interrupteurs S1 et S3 sont ouverts et les interrupteurs S2 et S4 sont fermés. La fréquence de commutation du pont H1 entre les première et deuxième configurations, appelée fréquence de découpage, est de préférence choisie très supérieure à la fréquence de la tension alternative à convertir, par exemple comprise entre 200 kHz et 20 MHz pour une fréquence d'entrée de l'ordre de 20 à 100 Hz. Le rapport cyclique φH1 de la commutation entre les première et deuxième configurations du pont H1 est par exemple approximativement égal à 0,5.

Le circuit 101 commande en outre le pont secondaire H2 alternativement dans une première configuration dans laquelle les interrupteurs S5 et S7, définissant une première diagonale du pont, sont fermés et les interrupteurs S6 et S8, définissant une deuxième diagonale du pont, sont ouverts, et dans une deuxième configuration dans laquelle les interrupteurs S5 et S7 sont ouverts et les interrupteurs S6 et S8 sont fermés. La fréquence de commutation du pont H2 entre les première et deuxième configurations est sensiblement égale à la fréquence de commutation du pont H1. Lors du passage de la première configuration à la deuxième configuration, le circuit 101 peut en outre commander le pont H2 dans une première configuration intermédiaire dans laquelle les interrupteurs S5 et S8 sont fermés et les interrupteurs S6 et S7 sont ouverts. De plus, lors du passage de la deuxième configuration à la première configuration, le circuit 101 peut commander le pont H2 dans une deuxième configuration intermédiaire dans laquelle les interrupteurs S5 et S8 sont ouverts et les interrupteurs S6 et S7 sont fermés.

Le rapport cyclique φH2 de la commutation entre les première et deuxième configurations du pont H2 peut toutefois être différent du rapport cyclique φH1 du pont primaire. En outre, un déphasage δH1H2 peut être prévu entre la séquence de commande du pont primaire H1 et la séquence de commande du pont secondaire H2.

En jouant sur les paramètres φH2 et δH1H2, le circuit 101 régule la tension continue de sortie du convertisseur 100, et/ou le courant prélevé sur la source de tension alternative d'alimentation du convertisseur, par exemple pour assurer une absorption sinusoïdale du courant fourni par la source alternative.

De plus, le convertisseur de la figure 1 est réversible. Ainsi, dans le cas où une charge L active, par exemple une batterie, est connectée en sortie du convertisseur, le circuit 101 peut, en jouant sur les paramètres φH1, φH2 et/ou δH1H2 susmentionnés, commander un transfert d'énergie électrique DC-AC, de la charge continue L vers l'entrée alternative du convertisseur.

Selon un aspect du premier mode de réalisation, le circuit de commande 101 est configuré pour, lors des phases de transition entre la première configuration (diagonale S1, S3 passante et diagonale S2, S4 bloquée) et la deuxième configuration (diagonale S1, S3 bloquée et diagonale S2, S4 passante) du pont primaire H1, ne fermer les interrupteurs S2 et S4 que lorsque la tension à leurs bornes s'annule, et, lors des phases de transition entre la deuxième configuration (diagonale S1, S3 bloquée et diagonale S2, S4 passante) et la première configuration (diagonale S1, S3 passante et diagonale S2, S4 bloquée) du pont H1, ne fermer les interrupteurs S1 et S3 que lorsque la tension à leurs bornes s'annule.

Ceci permet de limiter de façon significative les pertes en commutation dans le pont primaire H1. La fréquence de découpage du convertisseur peut alors être choisie relativement élevée, par exemple supérieure à 1 MHz voire supérieure à 10 MHz, ce qui permet de diminuer significativement les dimensions du transformateur d'isolement T.

Dans un mode de réalisation préféré, les interrupteurs S1, S2, S3, S4 du pont primaire H1 et les interrupteurs S5, S6, S7, S8 du pont secondaire H2 sont des interrupteurs au nitrure de gallium, par exemple des interrupteurs du type décrit dans la demande de brevet EP2736078 précédemment déposée par la demanderesse, ou dans l'article intitulé "The single reference Bi-Directional GaN HEMT AC switch" de D. Bergogne et al. (Power Electronics and Applications (EPE'15 ECCE-Europe)). Les interrupteurs au nitrure de gallium sont en effet aptes à fonctionner à des fréquences de commutation élevées sans risques de dégradation. Les modes de réalisation décrits ne se limitent toutefois pas à cet exemple particulier.

La figure 2 est un chronogramme illustrant le fonctionnement du convertisseur 100 de la figure 1 lors d'une phase de transition de la première configuration (diagonale S1, S3 passante et diagonale S2, S4 bloquée) vers la deuxième configuration (diagonale S1, S3 bloquée et diagonale S2, S4 passante) du pont primaire H1.

Plus particulièrement, le chronogramme de la figure 2 comprend une première courbe V_{CO} représentant l'évolution, en fonction du temps, de la tension V_{CO} aux bornes du condensateur de sortie CO du pont primaire H1, une deuxième courbe V_{S1} représentant l'évolution, en fonction du temps, de la tension V_{S1} aux bornes de l'interrupteur S1, et une troisième courbe V_{S2} représentant l'évolution, en fonction du temps, de la tension V_{S2} aux bornes de l'interrupteur S2.

Dans l'exemple de la figure 2, on se place à un instant initial t0 auquel le pont primaire H1 est dans la première configuration. Les interrupteurs S1 et S3 sont alors passants et les interrupteurs S2 et S4 bloqués, et la tension V_{CO} aux bornes du condensateur CO est sensiblement égale à la valeur Vₑ de la tension alternative d'entrée du convertisseur à l'instant considéré, de l'ordre de 200 Volts dans l'exemple représenté. Compte tenu du fait que la fréquence de découpage du convertisseur est très supérieure à la fréquence de la tension alternative d'entrée du convertisseur, la tension alternative d'entrée est considérée constante pendant toute la durée d'une phase de transition entre les première et deuxième configurations du pont H1. A l'instant t0, la tension V_{S1} aux bornes de l'interrupteur S1 est sensiblement nulle (interrupteur S1 passant), et la tension V_{S2} aux bornes de l'interrupteur S2 est sensiblement égale à la valeur Vₑ (interrupteur S2 bloqué).

A un instant t1 postérieur à l'instant t0, marquant le début d'une phase de transition entre les première et deuxième configurations du pont primaire H1, le circuit 101 commande l'ouverture des interrupteurs S1 et S3, tout en maintenant les interrupteurs S2 et S4 à l'état ouvert. Pour assurer la continuité du courant circulant dans l'inductance l2 et/ou dans l'inductance formée par l'enroulement W1 du transformateur T, le condensateur CO se décharge alors entièrement, jusqu'à une valeur nulle, puis se charge négativement jusqu'à la valeur -Vₑ. Pendant la phase de décharge puis de charge négative du condensateur CO, la tension V_{S1} aux bornes de l'interrupteur S1 croit jusqu'à atteindre la valeur Vₑ, et la tension V_{S2} aux bornes de l'interrupteur S2 décroit jusqu'à une valeur nulle.

Le circuit de commande 101 est configuré pour détecter l'annulation de la tension V_{S2} aux bornes de l'interrupteur S2 suivant l'instant t1 d'ouverture des interrupteurs S1 et S3, et pour commander la fermeture de l'interrupteur S2 lorsque l'annulation de la tension V_{S2} est détectée.

Ainsi, à un instant t2 postérieur à l'instant t1, correspondant à l'instant d'annulation de la tension aux bornes de l'interrupteur S2, le circuit 101 commande la fermeture de l'interrupteur S2.

On notera que les tensions V_{S3} et V_{S4} aux bornes des interrupteurs S3 et S4 n'ont pas été représentées sur la figure 2, ces tensions ayant sensiblement la même évolution que les tensions V_{S1} et V_{S2} respectivement.

L'instant t2 marque la fin de la phase de transition entre les première et deuxième configurations du pont primaire H1. Les interrupteurs S2 et S4 sont alors passants et les interrupteurs S1 et S3 bloqués, et la tension V_{CO} aux bornes du condensateur CO est sensiblement égale à la valeur -Vₑ, de l'ordre de -200 Volts dans l'exemple représenté. A l'instant t2, la tension V_{S2} aux bornes de l'interrupteur S2 est sensiblement nulle, et la tension V_{S1} aux bornes de l'interrupteur S1 est sensiblement égale à la valeur Vₑ.

Le fonctionnement du convertisseur 100 lors des phases de transition de la deuxième configuration (diagonale S1, S3 bloquée et diagonale S2, S4 passante) vers la première configuration (diagonale S1, S3 passante et diagonale S2, S4 bloquée) du pont primaire H1 est similaire à ce qui vient d'être décrit, c'est-à-dire que le circuit 101 commande d'abord l'ouverture des interrupteurs S2 et S4, tout en maintenant les interrupteurs S1 et S3 à l'état ouvert, puis surveille la tension aux bornes des interrupteurs S1 et S3 de façon à ne commander la fermeture des interrupteurs S1 et S3 que lorsque la tension à leurs bornes s'annule.

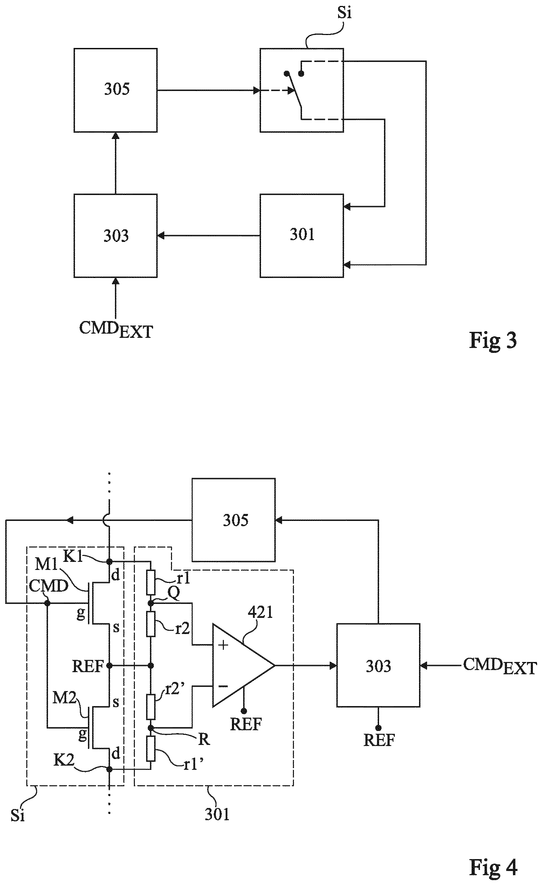

La figure 3 illustre de façon schématique et partielle un exemple de réalisation du circuit de commande 101 du convertisseur 100 de la figure 1. La figure 3 illustre plus particulièrement un interrupteur Si du pont primaire H1 du convertisseur, ainsi qu'un circuit de commande associé à cet interrupteur. Le circuit de commande représenté en figure 3 correspond à une partie du circuit de commande 101 de la figure 1. A titre d'exemple, chacun des interrupteurs S1, S2, S3, S4 du pont primaire H1 du convertisseur, est associé à un circuit de commande spécifique du type décrit en relation avec la figure 3.

Le circuit de commande de la figure 3 comprend, relié à l'interrupteur Si par ses noeuds de conduction principaux, un circuit 301 de détection du passage à une valeur nulle ou considérée comme nulle de la tension aux bornes de l'interrupteur Si. L'étage 301 fournit un signal logique de sortie indiquant si la tension aux bornes de l'interrupteur Si est ou non considérée comme nulle.

Le circuit de commande de la figure 3 comprend de plus un circuit 303 recevant le signal logique de sortie de l'étage 301, et recevant en outre un signal extérieur de commande CMD_{EXT}, fourni par un circuit centralisé de commande (non détaillé) du circuit 101 de la figure 1. Le circuit 303 réalise une opération logique entre le signal de sortie du circuit 301 et le signal extérieur de commande CMD_{EXT}, et fournit un signal logique de commande de l'interrupteur Si, correspondant au résultat de cette opération. A titre d'exemple, pour faire commuter le pont H1 de la première configuration (diagonale S1, S3 passante et diagonale S2, S4 bloquée) vers la deuxième configuration (diagonale S1, S3 bloquée et diagonale S2, S4 passante), le circuit centralisé de commande du circuit 101 envoie simultanément un ordre d'ouverture de l'interrupteur S1, un ordre d'autorisation de fermeture de l'interrupteur S2, un ordre d'ouverture de l'interrupteur S3, et un ordre d'autorisation de fermeture de l'interrupteur S4, via les entrées CMD_{EXT} des circuits 303 associés aux interrupteurs S1, S2, S3 et S4 respectivement. De façon similaire, pour faire commuter le pont H1 de la première configuration (diagonale S1, S3 bloquée et diagonale S2, S4 passante) vers la deuxième configuration (diagonale S1, S3 passante et diagonale S2, S4 bloquée), le circuit centralisé de commande du circuit 101 envoie simultanément un ordre d'autorisation de fermeture de l'interrupteur S1, un ordre d'ouverture de l'interrupteur S2, un ordre d'autorisation de fermeture de l'interrupteur S3, et un ordre d'ouverture de l'interrupteur S4, via les entrées CMD_{EXT} des circuits 303 associés aux interrupteurs S1, S2, S3 et S4 respectivement.

Pour chaque interrupteur Si, lorsque le circuit 303 associé à l'interrupteur reçoit un ordre d'ouverture de l'interrupteur, il applique directement un signal de commande en ouverture sur sa sortie, sans tenir compte du signal de sortie du circuit 301.

Lorsque le circuit logique 303 associé à un interrupteur Si reçoit un ordre d'autorisation de fermeture de l'interrupteur, il commence par maintenir sur sa sortie un signal de commande à l'état ouvert de l'interrupteur tant que le signal de sortie du circuit 301 n'indique pas une annulation de la tension aux bornes de l'interrupteur, puis il applique sur sa sortie un signal de commande en fermeture de l'interrupteur Si uniquement lorsque le signal de sortie du circuit 301 indique une annulation de la tension aux bornes de l'interrupteur.

Le circuit de commande de la figure 3 comprend en outre un circuit 305 de mise à niveau du signal de commande de l'interrupteur Si, par exemple un amplificateur de tension et/ou de courant (pour pouvoir charger la grille dans le cas d'un interrupteur MOS), dont l'entrée est reliée à la sortie du circuit 303 et dont la sortie est reliée à un noeud de commande de l'interrupteur Si. Le circuit 305 est adapté à transposer le signal logique de commande fourni par le circuit 303 en signal de niveau adapté à commander effectivement l'interrupteur.

La figure 4 est un schéma plus détaillé d'un exemple de réalisation du circuit de la figure 3. Le circuit de la figure 4 reprend les mêmes éléments que le circuit de la figure 3, et illustre plus en détail un exemple de réalisation de l'interrupteur Si et du circuit 301 de détection de l'annulation de la tension aux bornes de l'interrupteur Si.

Dans cet exemple, on considère un interrupteur Si équivalent à deux transistors MOS M1 et M2 connectés en anti-série par leurs sources (s). Les drains (d) des transistors M1 et M2 forment respectivement les deux noeuds de conduction K1 et K2 de l'interrupteur Si. Les grilles (g) des transistors M1 et M2 sont connectées en un noeud CMD formant le noeud de commande de l'interrupteur Si. Le noeud REF commun aux sources (s) des transistors M1 et M2 forme un noeud de référence de l'interrupteur, auquel est référencé le signal de commande appliqué sur le noeud CMD.

Le circuit 301 comprend un premier pont diviseur de tension résistif comprenant une résistance r1 en série avec une résistance r2, fournissant une image atténuée de la tension drain-source du transistor M1, et un deuxième pont diviseur de tension résistive comprenant une résistance r1' en série avec une résistance r2', fournissant une image atténuée de la tension drain-source du transistor M2. Dans cet exemple, la résistance r1 a une première extrémité connectée au noeud K1 et une deuxième extrémité connectée à un noeud Q, et la résistance r2 a une première extrémité connectée au noeud Q et une deuxième extrémité connectée au noeud REF. De plus, dans cet exemple, la résistance r1' a une première extrémité connectée au noeud K2 et une deuxième extrémité connectée à un noeud R, et la résistance r2' a une première extrémité connectée au noeud R et une deuxième extrémité connectée au noeud REF. A titre d'exemple, les résistances r1 et r1' sont identiques, et les résistances r2 et r2' sont identiques (aux dispersions de fabrication près).

Le circuit 301 comprend en outre un comparateur de tension 421 référencé au noeud REF. Le noeud de sortie Q du premier pont diviseur de tension (r1, r2) est relié à l'entrée positive (+) du comparateur 421, et le noeud de sortie R du deuxième pont diviseur de tension (r1', r2') est relié à l'entrée négative (-) du comparateur 421.

La sortie du comparateur 421 forme la sortie du circuit 301, reliée à l'entrée du circuit 303 (également référencé au noeud REF). Comme décrit précédemment en relation avec la figure 3, la sortie du circuit 303 est reliée à l'entrée de l'étage d'amplification 305, la sortie de l'étage d'amplification 305 étant reliée au noeud CMD de commande de l'interrupteur Si.

On notera que dans l'exemple de la figure 4, toute la chaîne de commande de l'interrupteur Si, de la détection du passage à zéro de la tension aux bornes de l'interrupteur jusqu'à la commande effective de l'interrupteur, est référencée au même potentiel, à savoir le potentiel du noeud de référence REF de l'interrupteur. Ainsi, le circuit de commande de la figure 4 ne comprend pas d'élément d'isolation ce qui permet une grande réactivité du circuit. En particulier, ceci permet de commander sans délai significatif la fermeture de l'interrupteur Si lors de l'annulation de la tension à ses bornes, et donc de maintenir à un niveau très faible les pertes en commutation dans l'interrupteur.

On notera que dans le mode de réalisation de la figure 1, les condensateurs C1, C2, C3, C4 permettent de ralentir les variations de tension aux bornes des interrupteurs S1, S2, S3, S4 du pont primaire H1 lors des commutations, de façon à faciliter la détection du passage à zéro de la tension à leurs bornes. A titre de variante, ces condensateurs peuvent être omis.

### Deuxième mode de réalisation - structure inductive

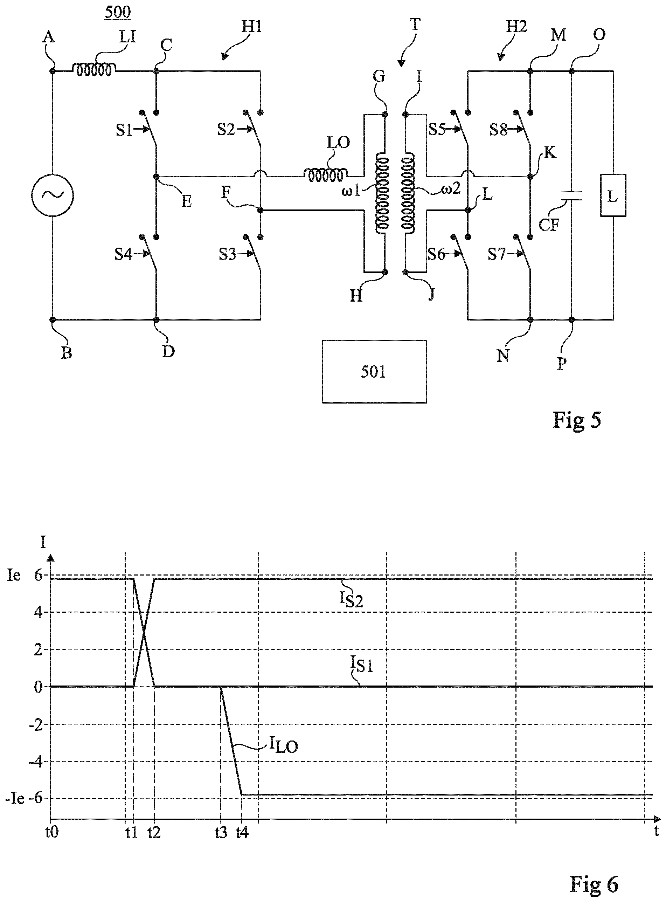

La figure 5 est un schéma électrique d'un exemple d'un convertisseur AC-DC 500 selon un deuxième mode de réalisation.

Le convertisseur 500 comprend un premier pont en H commandé H1, ou pont primaire, suivi d'un transformateur d'isolement T comprenant un enroulement primaire W1 et un enroulement secondaire W2 couplés magnétiquement, suivi d'un deuxième pont en H commandé H2, ou pont secondaire.

Le pont H1 est constitué de quatre interrupteurs commandés bidirectionnels en courant et en tension S1, S2, S3 et S4, par exemple identiques (aux dispersions de fabrication près), comportant chacun deux noeuds de conduction principaux et au moins un noeud de commande. Les interrupteurs S1 et S4 sont reliés en série, par leurs noeuds de conduction, entre des noeuds d'entrée C et D du pont. Les interrupteurs S2 et S3 sont reliés en série, par leurs noeuds de conduction, entre les noeuds C et D, en parallèle de la branche comprenant les interrupteurs S1 et S4. Le point milieu E entre les interrupteurs S1 et S4 définit un premier noeud de sortie du pont, et le point milieu F entre les interrupteurs S2 et S3 définit un deuxième noeud de sortie du pont. Plus particulièrement, dans l'exemple représenté, l'interrupteur S1 a un premier noeud de conduction connecté au noeud C et un deuxième noeud de conduction connecté au noeud E, l'interrupteur S4 a un premier noeud de conduction connecté au noeud E et un deuxième noeud de conduction connecté au noeud D, l'interrupteur S2 a un premier noeud de conduction connecté au noeud C et un deuxième noeud de conduction connecté au noeud F, et l'interrupteur S3 a un premier noeud de conduction connecté au noeud F et un deuxième noeud de conduction connecté au noeud D.

Les noeuds d'entrée C et D du pont H1 sont reliés directement, c'est-à-dire sans étage intermédiaire de redressement à diodes ni d'étage de filtrage passe-bas, à des noeuds A et B d'application de la tension alternative d'entrée du convertisseur.

Les noeuds de sortie E et F du pont H1 sont reliés aux extrémités G et H de l'enroulement primaire W1 du transformateur T.

Selon un aspect du deuxième mode de réalisation, le pont primaire H1 est purement inductif en entrée et en sortie. Plus particulièrement, le convertisseur 500 comprend une inductance LI connectée en série avec le pont, via les noeuds d'entrée C et D du pont, entre les noeuds A et B d'application de la tension alternative d'entrée du convertisseur, et une inductance LO connectée en série avec le pont, via les noeuds de sortie E et F du pont, entre les extrémités G et H de l'enroulement primaire W1 du transformateur T. Dans l'exemple représenté, l'inductance LI a une première extrémité connectée au noeud C et une deuxième extrémité connectée au noeud A, et le noeud D est connecté au noeud B. De plus, dans cet exemple, l'inductance LO a une première extrémité connectée au noeud E et une deuxième extrémité connectée au noeud G, et le noeud F est connecté au noeud H. Dans le mode de réalisation de la figure 5, le convertisseur ne comprend pas d'élément capacitif connecté en entrée du pont H1, entre les noeuds C et D, et ne comprend pas non plus d'élément capacitif connecté en sortie du pont H1, entre les noeuds E et F. On notera qu'il s'agit là encore d'un agencement inhabituel. En effet, en électronique de puissance, on prévoit généralement des éléments passifs d'échange d'énergie électrique de natures différentes en entrée et en sortie d'un même pont en H, pour des raisons de respect des règles d'association des sources.

Le pont H2 est constitué de quatre interrupteurs commandés S5, S6, S7 et S8, par exemple identiques (aux dispersions de fabrication près), comportant chacun deux noeuds de conduction principaux et au moins un noeud de commande. Les interrupteurs S5, S6, S7 et S8 sont par exemple des interrupteurs quasi-bidirectionnels, c'est-à-dire adaptés à laisser circuler du courant dans les deux sens, mais ne permettant un contrôle du courant que dans un sens (autrement dit des interrupteurs bidirectionnels en courant mais unidirectionnels en tension). A titre de variante, les interrupteurs S5, S6, S7, S8 sont des interrupteurs bidirectionnels en courant et en tension. Les interrupteurs S5 et S8 sont reliés en série, par leurs noeuds de conduction, entre des noeuds d'entrée K et L du pont. Les interrupteurs S6 et S7 sont reliés en série, par leurs noeuds de conduction, entre les noeuds K et L, en parallèle de la branche comprenant les interrupteurs S5 et S8. Le point milieu M entre les interrupteurs S5 et S8 définit un premier noeud de sortie du pont, et le point milieu N entre les interrupteurs S6 et S7 définit un deuxième noeud de sortie du pont. Plus particulièrement, dans l'exemple représenté, l'interrupteur S5 a un premier noeud de conduction connecté au noeud L et un deuxième noeud de conduction connecté au noeud M, l'interrupteur S8 a un premier noeud de conduction connecté au noeud M et un deuxième noeud de conduction connecté au noeud K, l'interrupteur S6 a un premier noeud de conduction connecté au noeud L et un deuxième noeud de conduction connecté au noeud N, et l'interrupteur S7 a un premier noeud de conduction connecté au noeud N et un deuxième noeud de conduction connecté au noeud K.

Les noeuds d'entrée K et L du pont H2 sont reliés respectivement aux extrémités I et J de l'enroulement secondaire W2 du transformateur T. Dans l'exemple représenté, l'extrémité I de l'enroulement W2 est connectée au noeud K et l'extrémité J de l'enroulement W2 est connectée au noeud L.

Le convertisseur 500 comprend en outre un condensateur de filtrage de sortie CF, en sortie du pont H2. Dans l'exemple représenté, les électrodes du condensateur CF sont connectées respectivement aux noeuds M et N de sortie du pont H2.

Les noeuds M et N de sortie du pont H2 sont reliés respectivement à des noeuds O et P de fourniture de la tension continue de sortie du convertisseur 500. Dans l'exemple représenté, le noeud M est connecté au noeud O et le noeud N est connecté au noeud P.

Le convertisseur 500 comprend en outre un circuit 501 (non détaillé) de commande des interrupteurs S1, S2, S3, S4, S5, S6, S7 et S8 des ponts H1 et H2.

En fonctionnement, une charge L à alimenter, par exemple une batterie électrique, peut être connectée entre les noeuds O et P de sortie du convertisseur.

Le fonctionnement du convertisseur 500 est le suivant. Le circuit 501 commande le pont primaire H1 alternativement dans une première configuration dans laquelle les interrupteurs S1 et S3, définissant une première diagonale du pont, sont fermés (passants) et les interrupteurs S2 et S4, définissant une deuxième diagonale du pont, sont ouverts (bloqués), et dans une deuxième configuration dans laquelle les interrupteurs S1 et S3 sont ouverts et les interrupteurs S2 et S4 sont fermés. Comme dans le premier mode de réalisation, la fréquence de commutation du pont H1 entre les première et deuxième configurations, ou fréquence de découpage, est de préférence choisie très supérieure à la fréquence de la tension alternative à convertir, par exemple comprise entre 200 kHz et 20 MHz pour une fréquence d'entrée de l'ordre de 20 à 100 Hz. Le rapport cyclique φH1 de la commutation entre les première et deuxième configurations du pont H1 est par exemple approximativement égal à 0,5.

Le circuit 501 commande en outre le pont secondaire H2 alternativement dans une première configuration dans laquelle les interrupteurs S5 et S7, définissant une première diagonale du pont, sont fermés et les interrupteurs S6 et S8, définissant une deuxième diagonale du pont, sont ouverts, et dans une deuxième configuration dans laquelle les interrupteurs S5 et S7 sont ouverts et les interrupteurs S6 et S8 sont fermés. La fréquence de commutation du pont H2 entre les première et deuxième configurations est sensiblement égale à la fréquence de commutation du pont H1. Le rapport cyclique φH2 de la commutation entre les première et deuxième configurations du pont H2 peut toutefois être différent du rapport cyclique φH1 du pont primaire. En outre, un déphasage δH1H2 peut être prévu entre la séquence de commande du pont primaire H1 et la séquence de commande du pont secondaire H2.

De même que dans le premier mode de réalisation, en jouant sur les paramètres φH2 et δH1H2, le circuit 501 régule la tension continue de sortie du convertisseur 500, et/ou le courant prélevé sur la source de tension alternative d'alimentation du convertisseur, par exemple pour assurer une absorption sinusoïdale du courant fourni par la source alternative.

De plus, comme dans le premier mode de réalisation, le convertisseur de la figure 5 est réversible. Ainsi, dans le cas où une charge L active, par exemple une batterie, est connectée en sortie du convertisseur, le circuit 501 peut, en jouant sur les paramètres φH1, φH2 et/ou δH1H2 susmentionnés, commander un transfert d'énergie électrique DC-AC, de la charge continue L vers l'entrée alternative du convertisseur.

Selon un aspect du deuxième mode de réalisation, le circuit de commande 501 est configuré pour, lors des phases de transition entre la première configuration (diagonale S1, S3 passante et diagonale S2, S4 bloquée) et la deuxième configuration (diagonale S1, S3 bloquée et diagonale S2, S4 passante) du pont primaire H1, n'ouvrir les interrupteurs S1 et S3 que lorsque le courant qui les traverse s'annule, et, lors des phases de transition entre la deuxième configuration (diagonale S1, S3 bloquée et diagonale S2, S4 passante) et la première configuration (diagonale S1, S3 passante et diagonale S2, S4 bloquée) du pont H1, n'ouvrir les interrupteurs S2 et S4 que lorsque le courant qui les traverse s'annule.

Ceci permet de limiter de façon significative les pertes en commutation dans le pont primaire H1. La fréquence de découpage du convertisseur peut alors être choisie relativement élevée, par exemple supérieure à 1 MHz voire supérieure à 10 MHz, ce qui permet de diminuer significativement les dimensions du transformateur d'isolement T.

Dans un mode de réalisation préféré, les interrupteurs S1, S2, S3, S4 du pont primaire H1 et les interrupteurs S5, S6, S7, S8 du pont secondaire H2 sont des interrupteurs au nitrure de gallium. Les modes de réalisation décrits ne se limitent toutefois pas à cet exemple particulier.

La figure 6 est un chronogramme illustrant le fonctionnement du convertisseur 500 de la figure 5 lors d'une phase de transition de la première configuration (diagonale S1, S3 passante et diagonale S2, S4 bloquée) vers la deuxième configuration (diagonale S1, S3 bloquée et diagonale S2, S4 passante) du pont primaire H1.

Plus particulièrement, le chronogramme de la figure 6 comprend une première courbe I_{LO} représentant l'évolution, en fonction du temps, du courant I_{LO} circulant dans l'inductance de sortie LO du pont primaire H1, une deuxième courbe I_{S1} représentant l'évolution, en fonction du temps, du courant I_{S1} circulant dans l'interrupteur S1, et une troisième courbe I_{S2} représentant l'évolution, en fonction du temps, du courant I_{S2} circulant dans l'interrupteur S2.

Dans l'exemple de la figure 6, on se place à un instant initial t0 auquel le pont primaire H1 est dans la première configuration. Les interrupteurs S1 et S3 sont alors passants et les interrupteurs S2 et S4 bloqués, et le courant I_{LO} circulant dans l'inductance LO est sensiblement égal au courant Iₑ circulant dans l'inductance d'entrée LI du pont H1 à l'instant considéré. Compte tenu du fait que la fréquence de découpage du convertisseur est très supérieure à la fréquence de la tension alternative d'entrée du convertisseur, le courant alternatif d'entrée Iₑ est considéré constant pendant toute la durée d'une phase de transition entre les première et deuxième configurations du pont H1. A l'instant t0, le courant I_{S1} dans l'interrupteur S1 est sensiblement égal au courant d'entrée Iₑ (interrupteur S1 passant), et le courant I_{S2} dans l'interrupteur S2 est sensiblement nul (interrupteur S2 bloqué). De plus, le courant I_{S3} (non représenté) dans l'interrupteur S3 est sensiblement égal au courant d'entrée Iₑ, et le courant I_{S4} (non représenté) dans l'interrupteur S4 est sensiblement nul.

A un instant t1 postérieur à l'instant t0, marquant le début d'une phase de transition entre les première et deuxième configurations du pont primaire H1, le circuit 501 commande la fermeture de l'interrupteur S2, tout en maintenant les interrupteurs S1 et S3 fermés et l'interrupteur S4 ouvert. L'inductance LO se décharge alors jusqu'à annuler le courant circulant dans l'enroulement primaire W1 du transformateur, et donc le courant I_{S1} circulant dans l'interrupteur S1. Dans le même temps, le courant I_{S2} croit jusqu'à atteindre la valeur Iₑ.

L'interrupteur S1 est configuré pour s'ouvrir automatiquement lorsque le courant qui le traverse s'annule. Ainsi, à un instant t2 postérieur à l'instant t1, l'interrupteur S1 s'ouvre.

A un instant t3 postérieur à l'instant t2, le circuit 501 commande la fermeture de l'interrupteur S4, tout en maintenant les interrupteurs S2 et S3 fermés et l'interrupteur S1 ouvert. L'inductance LO se charge alors négativement jusqu'à ce que le courant la traversant atteigne la valeur -Iₑ. Dans le même temps, le courant I_{S4} traversant l'interrupteur S4 croît jusqu'à atteindre la valeur Iₑ, et le courant I_{S3} traversant l'interrupteur S3 décroît jusqu'à s'annuler.

L'interrupteur S3 est configuré pour s'ouvrir automatiquement lorsque le courant qui le traverse s'annule. Ainsi, à un instant t4 postérieur à l'instant t3, l'interrupteur S3 s'ouvre.

L'instant t4 marque la fin de la phase de transition entre les première et deuxième configurations du pont primaire H1. Les interrupteurs S2 et S4 sont alors passants et les interrupteurs S1 et S3 bloqués.

Le fonctionnement du convertisseur 500 lors des phases de transition de la deuxième configuration (diagonale S1, S3 bloquée et diagonale S2, S4 passante) vers la première configuration (diagonale S1, S3 passante et diagonale S2, S4 bloquée) du pont primaire H1 est similaire à ce qui vient d'être décrit, c'est-à-dire que le circuit 501 commande d'abord la fermeture de l'interrupteur S1 tout en maintenant les interrupteurs S2 et S4 fermés et l'interrupteur S3 ouvert, puis, après l'ouverture automatique de l'interrupteur S2, la fermeture de l'interrupteur S3 tout en maintenant les interrupteurs S1 et S4 fermés et l'interrupteur S2 ouvert, jusqu'à l'ouverture automatique de l'interrupteur S4.

Ainsi, dans l'exemple de fonctionnement décrit en relation avec la figure 6, chacun des interrupteurs Si du pont primaire H1 doit pouvoir être commandé en fermeture par le circuit de commande 501, et doit être adapté, après une fermeture, à se rouvrir automatiquement lorsque le courant qui le traverse s'annule.

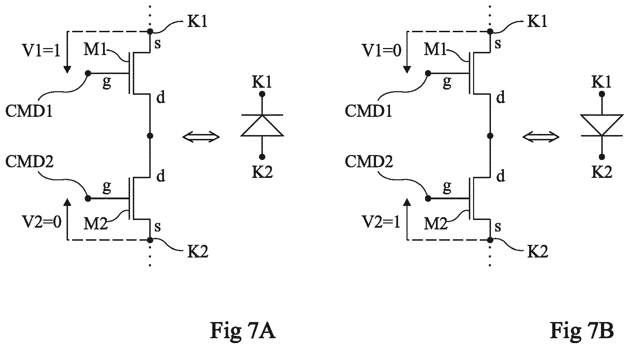

Les figures 7A et 7B illustrent de façon schématique un exemple de réalisation d'un interrupteur Si du pont primaire H1 adapté au mode de fonctionnement décrit en relation avec la figure 6.

Dans cet exemple, on considère un interrupteur Si équivalent à deux transistors MOS M1 et M2 connectés en anti-série par leurs drains (d). Les sources (s) des transistors M1 et M2 forment respectivement les deux noeuds de conduction K1 et K2 de l'interrupteur Si. La grille (g) du transistor M1 est connectée à un noeud CMD1 formant un premier noeud de commande de l'interrupteur Si. La grille (g) du transistor M2 est connectée à un noeud de CMD2 formant un deuxième noeud de commande de l'interrupteur Si.

Le circuit de commande 501 du convertisseur 500 est configuré pour, lorsqu'il commande la fermeture d'un interrupteur Si du pont primaire H1, amorcer l'interrupteur de façon qu'il se comporte comme une diode, et donc qu'il puisse s'ouvrir naturellement lorsque le courant entre ses noeuds de conduction K1 et K2 s'annule. Pour cela, lors de la fermeture de l'interrupteur Si, le circuit 501 applique un signal de commande en fermeture sur la grille de l'un des deux transistors M1 et M2 et maintien un signal de blocage sur la grille de l'autre transistor.

Plus particulièrement, dans l'exemple représenté, dans le cas où un courant négatif doit circuler entre les noeuds de conduction K1 et K2 de l'interrupteur, une tension grille-source positive est appliquée au transistor M1 (tension V1 entre le noeud CMD1 et le noeud K1), et une tension grille-source nulle ou négative est appliquée au transistor M2 (tension V2 entre le noeud CMD2 et le noeud K2). Dans ce cas, l'interrupteur Si se comporte comme une diode dont l'anode est connectée au noeud K2 et dont la cathode est connectée au noeud K1. Cette configuration est illustrée par la figure 7A.

Dans le cas où un courant positif doit circuler entre les noeuds de conduction K1 et K2 de l'interrupteur, une tension grille-source négative ou nulle est appliquée au transistor M1 (tension V1 entre le noeud CMD1 et le noeud K1), et une tension grille-source positive est appliquée au transistor M2 (tension V2 entre le noeud CMD2 et le noeud K2). Dans ce cas, l'interrupteur Si se comporte comme une diode dont l'anode est connectée au noeud K1 et dont la cathode est connectée au noeud K2. Cette configuration est illustrée par la figure 7B.

Dans l'exemple décrit ci-dessus en relation avec les figures 6 et 7A-7B, les interrupteurs Si sont commandés en fermeture et sont configurés pour se rouvrir automatiquement lorsque le courant qui les traverse s'annule. A titre de variante, le circuit de commande 501 est configuré pour détecter l'annulation du courant dans chaque interrupteur Si, et pour commander l'ouverture de l'interrupteur lorsque l'annulation du courant I_{Si} dans l'interrupteur est détectée.

A titre d'exemple, en se référant à nouveau à la figure 6, à l'instant t1, le circuit 501 commande la fermeture de l'interrupteur S2, tout en maintenant les interrupteurs S1 et S3 fermés et l'interrupteur S4 ouvert.

Le circuit de commande 501 est configuré pour détecter l'annulation du courant I_{S1} dans l'interrupteur S1 suivant l'instant t1 de fermeture de l'interrupteur S2, et pour commander l'ouverture de l'interrupteur S1 lorsque l'annulation du courant I_{S1} est détectée.

Ainsi, à un instant t2 postérieur à l'instant t1, correspondant à l'instant d'annulation du courant dans l'interrupteur S1, le circuit 501 commande l'ouverture de l'interrupteur S1.

A un instant t3 postérieur à l'instant t2, le circuit 501 commande la fermeture de l'interrupteur S4, tout en maintenant les interrupteurs S2 et S3 fermés et l'interrupteur S1 ouvert.

Le circuit de commande 501 est configuré pour détecter l'annulation du courant I_{S3} dans l'interrupteur S3 suivant l'instant t3 de fermeture de l'interrupteur S4, et pour commander l'ouverture de l'interrupteur S3 lorsque l'annulation du courant I_{S3} est détectée.

Ainsi, à un instant t4 postérieur à l'instant t3, correspondant à l'instant d'annulation du courant dans l'interrupteur S3, le circuit 501 commande l'ouverture de l'interrupteur S3.

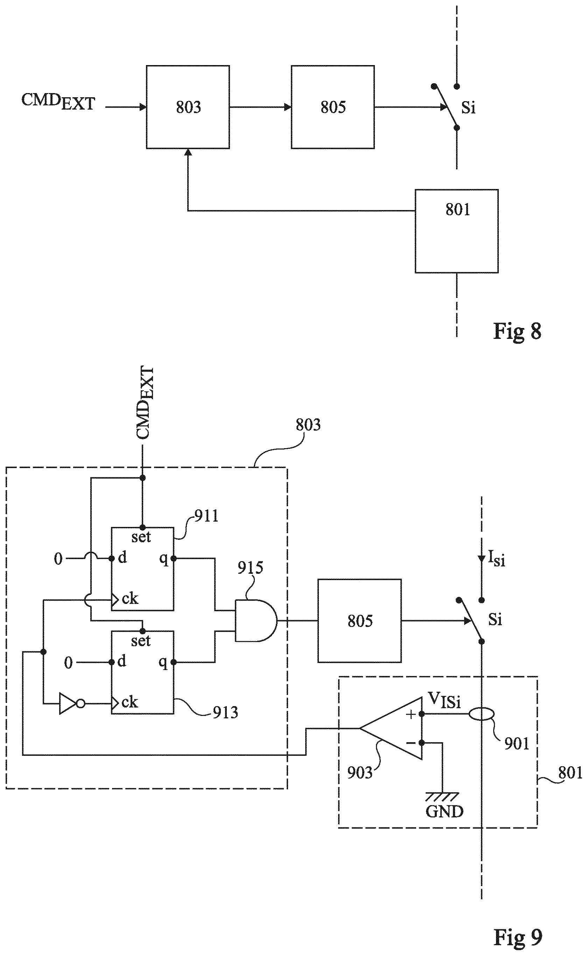

La figure 8 illustre de façon schématique et partielle un exemple de réalisation du circuit de commande 501 du convertisseur 500 de la figure 5. La figure 8 illustre plus particulièrement un interrupteur Si du pont primaire H1 du convertisseur, ainsi qu'un circuit de commande associé à cet interrupteur. Le circuit de commande représenté en figure 8 correspond à une partie du circuit de commande 501 de la figure 5. A titre d'exemple, chacun des interrupteurs S1, S2, S3, S4 du pont primaire H1 du convertisseur, est associé à un circuit de commande spécifique du type décrit en relation avec la figure 8.

Le circuit de commande de la figure 8 comprend, couplé à l'interrupteur Si, par exemple en série avec l'interrupteur Si, un circuit 801 de détection d'une annulation du courant dans l'interrupteur Si. L'étage 801 fournit un signal logique de sortie indiquant si le courant dans l'interrupteur Si est ou non considéré comme nul.

Le circuit de commande de la figure 8 comprend de plus un circuit 803 recevant le signal logique de sortie de l'étage 801, et recevant en outre un signal extérieur de commande CMD_{EXT}, fourni par un circuit centralisé de commande (non détaillé) du circuit 501 de la figure 5. Le circuit 803 réalise une opération logique entre le signal de sortie du circuit 801 et le signal extérieur de commande CMD_{EXT}, et fournit un signal logique de commande de l'interrupteur Si, correspondant au résultat de cette opération. A titre d'exemple, pour faire commuter le pont H1 de la première configuration (diagonale S1, S3 passante et diagonale S2, S4 bloquée) vers la deuxième configuration (diagonale S1, S3 bloquée et diagonale S2, S4 passante), le circuit centralisé de commande du circuit 501 envoie simultanément, à l'instant t1 un ordre de fermeture de l'interrupteur S2 et un ordre d'autorisation d'ouverture de l'interrupteur S1, via les entrées CMD_{EXT} des circuits 803 associés aux interrupteurs S2 et S1 respectivement. A l'instant t3, le circuit centralisé de commande du circuit 501 envoie simultanément un ordre de fermeture de l'interrupteur S4 et un ordre d'autorisation d'ouverture de l'interrupteur S3, via les entrées CMD_{EXT} des circuits 803 associés aux interrupteurs S4 et S3 respectivement.

Pour chaque interrupteur Si, lorsque le circuit 803 associé à l'interrupteur reçoit un ordre de fermeture de l'interrupteur, il applique directement un signal de commande en fermeture sur sa sortie, sans tenir compte du signal de sortie de l'étage 801.

Lorsque le circuit logique 803 associé à un interrupteur Si reçoit un ordre d'autorisation d'ouverture, il commence par maintenir sur sa sortie un signal de commande à l'état fermé de l'interrupteur tant que le signal de sortie du circuit 801 n'indique pas une annulation du courant dans l'interrupteur Si, puis il applique sur sa sortie un signal de commande en ouverture de l'interrupteur Si uniquement lorsque le signal de sortie du circuit 801 indique une annulation du courant dans l'interrupteur.

Le circuit de commande de la figure 8 comprend en outre un circuit 805 de mise à niveau du signal de commande de l'interrupteur Si, par exemple un amplificateur de tension et/ou de courant (pour pouvoir charger la grille dans le cas d'un interrupteur MOS), dont l'entrée est reliée à la sortie du circuit 803 et dont la sortie est reliée à un noeud de commande de l'interrupteur Si. Le circuit 805 est adapté à transposer le signal logique de commande fourni par le circuit 803 en signal de niveau adapté à commander effectivement l'interrupteur.

La figure 9 est un schéma plus détaillé d'un exemple de réalisation du circuit de la figure 8. Le circuit de la figure 9 reprend les mêmes éléments que le circuit de la figure 8, et illustre plus en détail un exemple de réalisation du circuit 801 de détection de l'annulation du courant dans l'interrupteur Si et du circuit logique 803 de génération du signal de commande de l'interrupteur Si.

Le circuit 801 comprend un dispositif 901 de mesure du courant circulant dans la branche du pont H1 comprenant l'interrupteur Si, c'est-à-dire, en se référant à la figure 5, entre les noeuds C et E pour l'interrupteur S1, entre les noeuds C et F pour l'interrupteur S2, entre les noeuds F et D pour l'interrupteur S3, et entre les noeuds E et D pour l'interrupteur S4. Dans cet exemple, le dispositif de mesure de courant 901 fournit une tension V_{ISi} représentative du courant I_{Si}. En particulier, dans cet exemple, le signe de la tension V_{ISi} est représentatif du signe du courant I_{Si}. A titre d'exemple, la tension V_{ISi} est proportionnelle au courant I_{Si}. Le dispositif de mesure de courant 901 est par exemple un capteur à effet hall, ou tout autre capteur de courant adapté. Le circuit 801 comprend de plus, dans cet exemple, un comparateur de tension 903 dont une première entrée (+) est reliée à la sortie du dispositif de mesure de courant 901 et dont une deuxième entrée (-) est reliée à un noeud GND d'application d'un potentiel de référence, par exemple la masse. Dans cet exemple, la tension de sortie V_{ISi} du dispositif de mesure de courant 901 est référencée par rapport au noeud GND. Ainsi, le signal de sortie du comparateur 903 est à un premier état, par exemple un état haut, lorsque le courant I_{Si} circule dans un premier sens, et à un deuxième état, par exemple un état bas, lorsque le courant I_{Si} circule dans le sens opposé. Dans cet exemple, le signal de sortie de l'étage 801 correspond au signal de sortie du comparateur 801.

Dans l'exemple de la figure 9, le circuit logique 803 comprend deux bascules D 911 et 913. Chaque bascule D comprend un premier noeud d'entrée d, un deuxième noeud d'entrée ck, un troisième noeud d'entrée set, et un noeud de sortie q. Le fonctionnement de chaque bascule D est le suivant. Lorsque le signal binaire appliqué sur le noeud d'entrée set de la bascule est à un premier état, par exemple à l'état bas, à chaque front montant du signal binaire appliqué sur le noeud d'entrée ck, le signal binaire appliqué sur le noeud d'entrée d est recopié et mémorisé sur le noeud de sortie q. Lorsque le signal binaire appliqué sur le noeud d'entrée set de la bascule à un deuxième état, par exemple à l'état haut, le signal fourni sur le noeud de sortie q est forcé à un état prédéterminé, par exemple à l'état haut, indépendamment des états des signaux appliqués sur les noeuds d'entrée d et ck.

Dans cet exemple, un signal binaire à l'état bas ('0') est appliqué en permanence sur les noeuds d'entrée d des bascules 911 et 913. A titre d'exemple, les noeuds d'entrée d des bascules 911 et 913 sont reliés à un noeud d'application d'un potentiel de référence, par exemple le noeud GND. Le noeud d'entrée ck de la bascule 911 est quant à lui directement relié à la sortie du comparateur 903, tandis que le noeud d'entrée ck de la bascule 913 est relié à la sortie du comparateur 903 par l'intermédiaire d'un inverseur. Les noeuds d'entrée set des bascules 911 et 913 sont reliés à un noeud d'application du signal de commande extérieur CMD_{EXT}.

Le circuit logique 803 de la figure 9 comprend en outre une porte logique ET 915 à deux entrées et une sortie. Les première et deuxième entrées de la porte ET sont reliées respectivement au noeud de sortie q de la bascule D 911 et au noeud de sortie q de la bascule D 913. La sortie de la porte ET constitue la sortie du circuit 803 et est reliée à l'entrée du circuit 805.

Le fonctionnement du circuit de commande de l'interrupteur Si de la figure 9 est le suivant. Pour commander la fermeture de l'interrupteur Si, le signal de commande CMD_{EXT} est mis à l'état haut. Les signaux binaires fournis sur les noeuds de sortie q des bascules 911 et 913 sont alors à l'état haut. Ainsi, le signal de sortie de la porte ET 915 est à l'état haut, et l'interrupteur est maintenu fermé (passant). Pour autoriser la réouverture automatique de l'interrupteur Si, le signal CMD_{EXT} est mis à l'état bas. Dans un premier temps, les sorties q des bascules 911 et 913 restent à l'état haut, de sorte que l'interrupteur Si reste fermé. Lorsque le courant I_{Si} dans l'interrupteur Si s'inverse, le signal de sortie du comparateur 903 change d'état. Il en résulte que le signal de sortie de l'une des deux bascules 911 et 913 passe à l'état bas. Ainsi, le signal de sortie de la porte ET 915 passe à l'état bas, ce qui entraine l'ouverture (blocage) de l'interrupteur Si.

Des modes de réalisation particuliers ont été décrits. Diverses variantes et modifications apparaîtront à l'homme de l'art. En particulier, les modes de réalisation décrits ne se limitent pas aux exemples de valeurs numériques mentionnés à titre d'exemple dans la présente description.

On notera en outre que le circuit de commande décrit en relation avec les figures 8 et 9, permettant de commander un interrupteur soit en fermeture forcée, soit pour s'ouvrir automatiquement lorsque le courant qui le traverse s'annule, peut avantageusement être utilisé pour d'autres applications que le convertisseur AC/DC décrit en relation avec les figures 5 et 6. A titre d'exemple, un tel circuit peut être utilisé pour commander un interrupteur d'un onduleur triphasé, ou, plus généralement, pour toute application pouvant tirer profit de l'ouverture automatique d'un interrupteur lorsque le courant qui le traverse s'annule.

## Revendications

1. Circuit (500) de conversion d'une tension alternative en une tension continue, comportant :
quatre premiers interrupteurs (S1, S2, S3, S4) bidirectionnels formant un premier pont en H (H1), des premier (C) et deuxième (D) noeuds d'entrée du pont (H1) étant reliés respectivement à des premier (A) et deuxième (B) noeuds d'application de la tension alternative ;
un transformateur (T) comportant un enroulement primaire (W1) et un enroulement secondaire (W2) couplés magnétiquement, des première (G) et deuxième (H) extrémités de l'enroulement primaire (W1) étant reliées respectivement à des premier (E) et deuxième (F) noeuds de sortie du premier pont (H1) ;
une première inductance (LI) connectée en série avec le premier pont (H1) entre le premier noeud (C) d'entrée du pont et le premier noeud (A) d'application de la tension alternative ;
une deuxième inductance (LO) connectée en série avec le premier pont (H1), entre le premier noeud (E) de sortie du pont et la première extrémité (G) de l'enroulement primaire (W1) ; et
un circuit de commande (501) adapté à commander le premier pont (H1) en alternance dans une première configuration dans laquelle les interrupteurs (S1, S3) d'une première diagonale du pont sont fermés et les interrupteurs d'une deuxième diagonale (S2, S4) du pont sont ouverts, et dans une deuxième configuration dans laquelle les interrupteurs (S1, S3) de la première diagonale sont ouverts et les interrupteurs (S2, S4) de la deuxième diagonale sont fermés,
le circuit de commande (501) étant adapté, lors d'une phase de transition entre les première et deuxième configurations, à, successivement :
fermer un premier interrupteur (S2) de la deuxième diagonale (S2, S4), tout en maintenant le premier interrupteur (S1) de la première diagonale (S1, S3) et le deuxième interrupteur (S3) de la première diagonale (S1, S3) fermés et le deuxième interrupteur (S4) de la deuxième diagonale (S2, S4) ouvert ;
ouvrir un premier interrupteur (S1) de la première diagonale (S1, S3) lorsque le courant traversant cet interrupteur s'annule ;
fermer le deuxième interrupteur (S4) de la deuxième diagonale (S2, S4), tout en maintenant le premier interrupteur (S2) de la deuxième diagonale (S2, S4) et le deuxième interrupteur (S3) de la première diagonale (S1, S3) fermés et le premier interrupteur (S1) de la première diagonale (S1, S3) ouvert ; et
ouvrir le deuxième interrupteur (S3) de la première diagonale (S1, S3) lorsque le courant traversant cet interrupteur s'annule.

2. Circuit de conversion (500) selon la revendication 1, comprenant en outre quatre deuxièmes interrupteurs (S5, S6, S7, S8) formant un deuxième pont en H (H2), des premier (K) et deuxième (L) noeuds d'entrée du deuxième pont (H2) étant reliés respectivement à des première (I) et deuxième (J) extrémités de l'enroulement secondaire (W2) du transformateur (T), et des premier (M) et deuxième (N) noeuds de sortie du deuxième pont (H2) étant reliés respectivement à des premier (O) et deuxième (P) noeuds de fourniture de la tension continue.

3. Circuit de conversion (500) selon la revendication 2, dans lequel le circuit de commande (501) est adapté à commander le deuxième pont (H2) en alternance dans une première configuration dans laquelle les interrupteurs (S6, S8) d'une première diagonale du pont sont fermés et les interrupteurs (S5, S7) d'une deuxième diagonale du pont sont ouverts, et dans une deuxième configuration dans laquelle les interrupteurs (S6, S8) de la première diagonale sont ouverts et les interrupteurs (S5, S7) de la deuxième diagonale sont fermés.

4. Circuit de conversion (500) selon la revendication 3, dans lequel le circuit de commande (501) est configuré pour commuter le premier pont (H1) entre ses première et deuxième configurations et pour commuter le deuxième pont (H2) entre ses première et deuxième configurations sensiblement à la même fréquence.

5. Circuit de conversion (500) selon l'une quelconque des revendications 1 à 4, dans lequel le circuit de commande (501) est configuré pour commuter le premier pont (H1) entre ses première et deuxième configurations à une fréquence supérieure ou égale à 1 MHz.

6. Circuit de conversion (500) selon l'une quelconque des revendications 1 à 5, dans lequel chaque premier interrupteur (Si) est adapté à être commandé en fermeture par le circuit de commande (501) et à s'ouvrir automatiquement lorsque le courant qui le traverse s'annule.

7. Circuit de conversion (500) selon l'une quelconque des revendications 1 à 6, dans lequel chaque premier interrupteur (Si) est équivalent à une association en anti-série de premier (M1) et deuxième (M2) transistors MOS connectés par leurs drains, les sources des premier (M1) et deuxième (M2) transistors formant respectivement les noeuds de conduction (K1, K2) de l'interrupteur (Si), et les grilles des premier (M1) et deuxième (M2) transistors MOS formant des premier (CMD1) et deuxième (CMD2) noeuds de commande de l'interrupteur.

8. Circuit de conversion (500) selon la revendication 7, dans lequel le circuit de commande (501) est configuré pour, lorsqu'il commande la fermeture d'un interrupteur (Si) du premier pont (H1), appliquer un signal de commande en fermeture sur la grille de l'un des premier (M1) et deuxième (M2) transistors de l'interrupteur et maintenir un signal de blocage sur la grille de l'autre transistor.

9. Circuit de conversion (500) selon la revendication 8, dans lequel le circuit de commande (501) est configuré pour, lorsqu'il commande la fermeture d'un interrupteur (Si) du premier pont (H1), appliquer un signal de commande en fermeture sur la grille du premier transistor (M1) et un signal de blocage sur la grille du deuxième transistor (M2) lorsque le courant que doit conduire l'interrupteur (Si) est d'une première polarité, et appliquer un signal de commande en fermeture sur la grille du deuxième transistor (M2) et un signal de blocage sur la grille du premier transistor (M1) lorsque le courant que doit conduire l'interrupteur (Si) est d'une deuxième polarité opposée à la première polarité.

10. Circuit de conversion (500) selon l'une quelconque des revendications 1 à 5, dans lequel le circuit de commande (501) comprend, pour chaque premier interrupteur (Si) :
un premier circuit (801) adapté à détecter une annulation du courant (I_{Si}) dans l'interrupteur (Si) et à fournir un signal logique de sortie correspondant au résultat de cette détection ;
un deuxième circuit (803) adapté à réaliser une opération logique entre le signal fourni par le premier circuit (801) et un signal extérieur (CMD_{EXT}) de commande de l'interrupteur, et à fournir un signal logique de commande de l'interrupteur correspondant au résultat de cette opération.

11. Circuit de conversion (500) selon la revendication 10, dans lequel, pour chaque premier interrupteur (Si), le premier circuit (801) du circuit de commande comprend un dispositif (901) de mesure du courant (I_{Si}) circulant dans l'interrupteur (Si) et un comparateur (903) configuré pour comparer un signal de sortie (V_{ISi}) du dispositif de mesure de courant (901) à un signal de référence.

12. Circuit de conversion (500) selon la revendication 11, dans lequel, pour chaque premier interrupteur (Si), le deuxième circuit (803) du circuit de commande comprend des première (911) et deuxième (913) bascules D comprenant chacune des premier (d), deuxième (ck) et troisième (set) noeuds d'entrée, et un noeud (q) de sortie, chaque bascule D étant adaptée:
- lorsqu'un signal binaire à un premier état est appliqué sur son troisième noeud d'entrée (set), à recopier sur son noeud de sortie (q), à chaque front montant d'un signal binaire appliqué sur son deuxième noeud d'entrée (ck), un signal binaire appliqué sur son premier noeud d'entrée (d) ;
- lorsqu'un signal binaire à un deuxième état est appliqué sur son troisième noeud d'entrée (set), à forcer le signal binaire fourni sur son noeud de sortie (q) à un état prédéterminé indépendamment des états des signaux appliqués sur ses premier (d) et deuxième (ck) noeuds d'entrée.

13. Circuit de conversion (500) selon la revendication 12, dans lequel, pour chaque premier interrupteur (Si) :
- chaque bascule D (911, 913) a son premier noeud d'entrée (d) relié à un noeud d'application d'un signal binaire fixe d'un premier état ;
- chaque bascule D (911, 913) a son troisième noeud d'entrée (set) relié à un noeud d'application du signal extérieur (CMD_{EXT}) de commande de l'interrupteur ; et
- la première bascule D (911) a son deuxième noeud d'entrée (ck) relié à la sortie du comparateur (903) et la deuxième bascule D (913) a son deuxième noeud d'entrée (ck) relié à la sortie du comparateur (903) par l'intermédiaire d'un inverseur.

14. Circuit de conversion (500) selon la revendication 13, dans lequel, pour chaque premier interrupteur (Si), le deuxième circuit (803) du circuit de commande comprend une porte ET (915) ayant une première entrée reliée au noeud de sortie (q) de la première bascule D (911), une deuxième entrée reliée au noeud de sortie (q) de la deuxième bascule D (913), et une sortie reliée à un noeud de fourniture du signal logique de sortie du deuxième circuit (803).

15. Circuit de conversion (500) selon l'une quelconque des revendications 1 à 14, dans lequel les premiers interrupteurs (S1, S2, S3, S4) sont des interrupteurs au nitrure de gallium.

## Patentansprüche

1. Gleichspannung-zu-Wechselspannung-Umwandlungsschaltung (500), die Folgendes aufweist:
vier erste bidirektionale Schalter (S1, S2, S3, S4), die eine erste H-Brücke (H1) bilden, wobei erste (C) und zweite (D) Eingangsknoten der Brücke (H1) jeweils mit ersten (A) und zweiten (B) Knoten zum Anlegen der Wechselspannung gekoppelt sind;
einen Transformator (T), der eine Primärwicklung (W1) und eine Sekundärwicklung (W2) aufweist, die magnetisch gekoppelt sind, wobei das erste (G) und zweite (H) Ende der Primärwicklung (W1) jeweils mit ersten (E) und zweiten (F) Ausgangsknoten der ersten Brücke (H1) gekoppelt sind;
eine erste Induktivität (L1), die mit der ersten Brücke (H1) zwischen dem ersten Eingangsknoten (C) der Brücke und dem ersten Knoten (A) zum Anlegen der Wechselspannung in Reihe geschaltet ist;
eine zweite Induktivität (LO), die mit der ersten Brücke (H1) zwischen dem ersten Ausgangsknoten (E) der Brücke und dem ersten Ende (G) der Primärwicklung (W1) in Reihe geschaltet ist; und
eine Steuerschaltung (501), die geeignet ist, die Brücke (H1) abwechselnd zu einer ersten Konfiguration zu steuern, wobei die Schalter (S1, S3) einer ersten Diagonale der Brücke eingeschaltet sind und die Schalter einer zweiten Diagonale (S2, S4) der Brücke ausgeschaltet sind, und zu einer zweiten Konfiguration, wobei die Schalter (S1, S3) der ersten Diagonale ausgeschaltet sind und die Schalter (S2, S4) der zweiten Diagonale eingeschaltet sind,
wobei die Steuerschaltung (501) geeignet ist, während einer Phase des Übergangs zwischen der ersten und zweiten Konfiguration aufeinanderfolgend zum:
Einschalten eines ersten Schalters (S2) der zweiten Diagonale (S2, S4), während der erste Schalter (S1) der ersten Diagonale (S1, S3) und der zweite Schalter (S3) der ersten Diagonale (S1, S3) im eingeschalteten Zustand und der zweite Schalter (S4) der zweiten Diagonale (S2, S4) im ausgeschalteten Zustand gehalten werden;
Ausschalten eines ersten Schalters (S1) der ersten Diagonale (S1, S3), wenn der durch diesen Schalter fließende Strom einen Nullwert annimmt;
Einschalten des zweiten Schalters (S4) der zweiten Diagonale (S2, S4), während der erste Schalter (S2) der zweiten Diagonale (S2, S4) und der zweite Schalter (S3) der ersten Diagonale (S1, S3) im eingeschalteten Zustand und der erste Schalter (S1) der ersten Diagonale (S1, S3) im ausgeschalteten Zustand gehalten wird; und
Ausschalten des zweiten Schalters (S3) der ersten Diagonale (S1, S3), wenn der durch diesen Schalter fließende Strom einen Nullwert annimmt.

2. Die Umwandlungsschaltung (500) nach Anspruch 1, die ferner vier zweite Schalter (S5, S6, S7, S8) aufweist, die eine zweite H-Brücke (H2) bilden, wobei erste (K) und zweite (L) Eingangsknoten der zweiten Brücke (H2) jeweils mit den ersten (I) und zweiten (J) Enden der Sekundärwicklung (W2) des Transformators (T) gekoppelt sind, und erste (M) und zweite (N) Ausgangsknoten der zweiten Brücke (H2) jeweils mit ersten (O) und zweiten (P) Gleichspannungsversorgungsknoten gekoppelt sind.

3. Umwandlungsschaltung (500) nach Anspruch 2, wobei die Steuerschaltung (501) geeignet ist, die zweite Brücke (H2) abwechselnd zu einer ersten Konfiguration zu steuern, bei der die Schalter (S6, S8) einer ersten Diagonale der Brücke eingeschaltet sind und die Schalter einer zweiten Diagonale (S5, S7) der Brücke ausgeschaltet sind, und zu einer zweiten Konfiguration, bei der die Schalter (S6, S8) der ersten Diagonale ausgeschaltet sind und die Schalter (S5, S7) der zweiten Diagonale eingeschaltet sind.

4. Umwandlungsschaltung (500) nach Anspruch 3, wobei die Steuerschaltung (501) konfiguriert ist, um die erste Brücke (H1) zwischen ihrer ersten und zweiten Konfiguration und die zweite Brücke (H2) zwischen ihrer ersten und zweiten Konfiguration im Wesentlichen mit der gleichen Frequenz zu schalten.

5. Umwandlungsschaltung (500) nach einem der Ansprüche 1 bis 4, wobei die Steuerschaltung (501) konfiguriert ist, um die erste Brücke (H1) zwischen ihrer ersten und zweiten Konfiguration bei einer Frequenz größer als oder gleich 1 MHz zu schalten.

6. Umwandlungsschaltung (500) nach einem der Ansprüche 1 bis 5, wobei jeder erste Schalter (Si) von der Steuerschaltung (501) in den eingeschalteten Zustand gesteuert werden kann und automatisch abschaltet, wenn der durch ihn fließende Strom einen Nullwert annimmt.

7. Umwandlungsschaltung (500) nach einem der Ansprüche 1 bis 6, wobei jeder erste Schalter (Si) einer antiseriellen Zuordnung von ersten (M1) und zweiten (M2) MOS-Transistoren entspricht, die durch ihre Drains verbunden sind, wobei die Sources des ersten (M1) und zweiten (M2) Transistors jeweils die Leitungsknoten (K1, K2) des Schalters (Si) bilden, und das Gate der ersten (M1) und zweiten (M2) MOS-Transistoren einen ersten (CMD1) und einen zweiten (CMD2) Schalt-Steuerknoten bilden.

8. Umwandlungsschaltung (500) nach Anspruch 7, wobei die Steuerschaltung (501) konfiguriert ist, um, wenn sie einen Schalter (Si) der ersten Brücke (H1) in den eingeschalteten Zustand steuert, ein Einschaltsteuersignal an das Gate eines der ersten (M1) und zweiten (M2) Transistoren des Schalters anzulegen und ein Sperrsignal am Gate des anderen Transistors zu halten.

9. Umwandlungsschaltung (500) nach Anspruch 8, wobei die Steuerschaltung (501) konfiguriert ist, um, wenn sie einen Schalter (Si) der ersten Brücke (H1) in den eingeschalteten Zustand steuert, ein Einschaltsteuersignal an das Gate des ersten Transistors (M1) und ein Abschaltsignal an das Gate des zweiten Transistors (M2) anzulegen, wenn der von dem Schalter (Si) zu leitende Strom eine erste Vorspannung aufweist, und ein Einschaltsteuersignal an das Gate des zweiten Transistors (M2) und ein Abschaltsignal an das Gate des ersten Transistors (M1) anzulegen, wenn der von dem Schalter (Si) zu leitende Strom eine zweite Vorspannung gegenüber der ersten Vorspannung aufweist.

10. Umwandlungsschaltung (500) nach einem der Ansprüche 1 bis 5, wobei die Steuerschaltung (501) für jeden ersten Schalter (Si) Folgendes aufweist:
eine erste Schaltung (801), die geeignet ist, zu detektieren, dass der Strom (I_{Si}) in dem Schalter (Si) einen Nullwert angenommen hat, und ein logisches Ausgangssignal entsprechend dem Ergebnis dieser Detektion zu liefern;
eine zweite Schaltung (803), die geeignet ist, eine logische Operation zwischen dem von der ersten Schaltung (801) gelieferten Signal und einem externen Schalt-Steuersignal (CMD_{EXT}) durchzuführen und ein logisches Schalt-Steuersignal entsprechend dem Ergebnis dieser Operation zu liefern.

11. Umwandlungsschaltung (500) nach Anspruch 10, wobei für jeden ersten Schalter (Si) die erste Schaltung (801) der Steuerschaltung eine Vorrichtung (901) zum Messen des durch den Schalter (Si) fließenden Stroms (I_{Si}) und einen Komparator (903) aufweist, der zum Vergleichen eines Ausgangssignals (V_{ISi}) der Strommessvorrichtung (901) mit einem Referenzsignal konfiguriert ist.

12. Umwandlungsschaltung (500) nach Anspruch 11, wobei für jeden ersten Schalter (Si) die zweite Schaltung (803) der Steuerschaltung erste (911) und zweite (913) D-Flip-Flops aufweist, die jeweils erste (d), zweite (ck) und dritte (set) Eingangsknoten und einen Ausgangsknoten (q) aufweisen, wobei jedes D-Flip-Flop geeignet ist zum:
- wenn ein Binärsignal in einem ersten Zustand an seinen dritten Eingangsknoten (set) angelegt wird, Kopieren auf seinen Ausgangsknoten (q) bei jeder steigenden Flanke eines Binärsignals, das an seinen zweiten Eingangsknoten (ck) angelegt wird, eines Binärsignals, das an seinen ersten Eingangsknoten (d) angelegt wird;
- wenn ein Binärsignal in einem zweiten Zustand an seinen dritten Eingangsknoten (set) angelegt wird, Zwingen des an seinem Ausgangsknoten (q) angelegten Binärsignals in einen vorbestimmten Zustand unabhängig von den Zuständen der an seinen ersten (d) und zweiten (ck) Eingangsknoten angelegten Signale.

13. Umwandlungsschaltung (500) nach Anspruch 12, wobei für jeden ersten Schalter (Si):
- jeder D-Flip-Flop (911, 913) seinen ersten Eingangsknoten (d) mit einem Knoten zum Anlegen eines festen binären Signals in einem ersten Zustand gekoppelt ist;
- jeder D-Flip-Flop (911, 913) seinen dritten Eingangsknoten (set) mit einem Knoten zum Anlegen des externen Schalt-Steuersignals (CMD_{EXT}) gekoppelt ist; und
- der erste D-Flip-Flop (911) seinen zweiten Eingangsknoten (ck) mit dem Ausgang des Komparators (903) gekoppelt ist, und der zweite D-Flip-Flop (913) seinen zweiten Eingangsknoten (ck) mit dem Ausgang des Komparators (903) über einen Inverter gekoppelt ist.

14. Umwandlungsschaltung (500) nach Anspruch 13, wobei für jeden ersten Schalter (Si) die zweite Schaltung (803) der Steuerschaltung ein UND-Gate (915) mit einem ersten Eingang, der mit dem Ausgangsknoten (q) des ersten D-Flip-Flops (911) gekoppelt ist, einem zweiten Eingang, der mit dem Ausgangsknoten (q) des zweiten D-Flip-Flops (913) gekoppelt ist, und einem Ausgang, der mit einem Knoten zum Liefern des logischen Ausgangssignals der zweiten Schaltung (803) gekoppelt ist, aufweist.

15. Umwandlungsschaltung (500) nach einem der Ansprüche 1 bis 14, wobei die ersten Schalter (S1, S2, S3, S4) Galliumnitridschalter sind.

## Claims

1. An AC-voltage-to-DC-voltage conversion circuit (500), comprising:
four first bidirectional switches (S1, S2, S3, S4) forming a first H bridge (H1), first (C) and second (D) input nodes of the bridge (H1) being respectively coupled to first (A) and second (B) nodes of application of the AC voltage;
a transformer (T) comprising a primary winding (W1) and a secondary winding (W2), magnetically coupled, first (G) and second (H) ends of the primary winding (W1) being respectively coupled to first (E) and second (F) output nodes of the first bridge (H1);
a first inductance (L1) series-connected with the first bridge (H1) between the first input node (C) of the bridge and the first node (A) of application of the AC voltage;
a second inductance (LO) series-connected with the first bridge (H1), between the first output node (E) of the bridge and the first end (G) of the primary winding (W1); and
a control circuit (501) capable of controlling the bridge (H1) alternately to a first configuration where the switches (S1, S3) of a first diagonal of the bridge are on and the switches of a second diagonal (S2, S4) of the bridge are off, and to a second configuration where the switches (S1, S3) of the first diagonal are off and the switches (S2, S4) of the second diagonal are on,
the control circuit (501) being capable, during a phase of transition between the first and second configurations, of successively:
turning on a first switch (S2) of the second diagonal (S2, S4), while holding the first switch (S1) of the first diagonal (S1, S3) and the second switch (S3) of the first diagonal (S1, S3) in the on state and the second switch (S4) of the second diagonal (S2, S4) in the off state;
turning off a first switch (S1) of the first diagonal (S1, S3) when the current flowing through this switch takes a zero value;
turning on the second switch (S4) of the second diagonal (S2, S4), while holding the first switch (S2) of the second diagonal (S2, S4) and the second switch (S3) of the first diagonal (S1, S3) in the on state and the first switch (S1) of the first diagonal (S1, S3) in the off state; and
turning off the second switch (S3) of the first diagonal (S1, S3) when the current flowing through this switch takes a zero value.

2. The conversion circuit (500) of claim 1, further comprising four second switches (S5, S6, S7, S8) forming a second H bridge (H2), first (K) and second (L) input nodes of the second bridge (H2) being respectively coupled to first (I) and second (J) ends of the secondary winding (W2) of the transformer (T), and first (M) and second (N) output nodes of the second bridge (H2) being respectively coupled to first (O) and second (P) DC voltage supply nodes.

3. The conversion circuit (500) of claim 2, wherein the control circuit (501) is capable of controlling the second bridge (H2) alternately to a first configuration where the switches (S6, S8) of a first diagonal of the bridge are on and the switches of a second diagonal (S5, S7) of the bridge are off, and to a second configuration where the switches (S6, S8) of the first diagonal are off and the switches (S5, S7) of the second diagonal are on.

4. The conversion circuit (500) of claim 3, wherein the control circuit (501) is configured to switch the first bridge (H1) between its first and second configurations and to switch the second bridge (H2) between its first and second configurations substantially at the same frequency.

5. The conversion circuit (500) of any of claims 1 to 4, wherein the control circuit (501) is configured to switch the first bridge (H1) between its first and second configurations at a frequency greater than or equal to 1 MHz.

6. The conversion circuit (500) of any of claims 1 to 5, wherein each first switch (Si) is capable of being controlled to the on state by the control circuit (501) and of automatically turning off when the current flowing therethrough takes a zero value.

7. The conversion circuit (500) of any of claims 1 to 6, wherein each first switch (Si) is equivalent to an anti-series association of first (M1) and second (M2) MOS transistors connected by their drains, the sources of the first (M1) and second (M2) transistors respectively forming the conduction nodes (K1, K2) of the switch (Si), and the gates of the first (M1) and second (M2) MOS transistors forming first (CMD1) and second (CMD2) switch control nodes.

8. The conversion circuit (500) of claim 7 wherein the control circuit (501) is configured to, when it controls a switch (Si) of the first bridge (H1) to the on state, apply a turn-on control signal to the gate of one of the first (M1) and second (M2) transistors of the switch and hold a blocking signal on the gate of the other transistor.

9. The conversion circuit (500) of claim 8, wherein the control circuit (501) is configured to, when it controls a switch (Si) of the first bridge (H1) to the on state, apply a turn-on control signal to the gate of the first transistor (M1) and a turn-off signal to the gate of the second transistor (M2) when the current to be conducted by the switch (Si) has a first biasing, and apply a turn-on control signal to the gate of the second transistor (M2) and a turn-off signal to the gate of the first transistor (M1) when the current to be conducted by the switch (Si) has a second biasing opposite to the first biasing.

10. The conversion circuit (500) of any of claims 1 to 5, wherein the control circuit (501) comprises, for each first switch (Si):
a first circuit (801) capable of detecting that the current (I_{Si}) in the switch (Si) has taken a zero value and of supplying a logic output signal corresponding to the result of this detection;
a second circuit (803) capable of performing a logic operation between the signal supplied by the first circuit (801) and an external switch control signal (CMD_{EXT}), and of supplying a logic switch control signal corresponding to the result of this operation.

11. The conversion circuit (500) of claim 10, wherein, for each first switch (Si), the first circuit (801) of the control circuit comprises a device (901) for measuring the current (I_{Si}) flowing through the switch (Si) and a comparator (903) configured to compare an output signal (V_{ISi}) of the current measurement device (901) with a reference signal.

12. The conversion circuit (500) of claim 11, wherein, for each first switch (Si), the second circuit (803) of the control circuit comprises first (911) and second (913) D flip-flops each comprising first (d), second (ck), and third (set) input nodes, and an output node (q), each D flip-flop being capable of:
- when a binary signal in a first state is applied to its third input node (set), copying on its output node (q), on each rising edge of a binary signal applied to its second input node (ck), a binary signal applied to its first input node (d);
- when a binary signal in a second state is applied to its third input node (set), forcing the binary signal supplied on its output node (q) to a predetermined state independently from the states of the signals applied to its first (d) and second (ck) input nodes.

13. The conversion circuit (500) of claim 12, wherein, for each first switch (Si):
- each D flip-flop (911, 913) has its first input node (d) coupled to a node of application of a fixed binary signal in a first state;
- each D flip-flop (911, 913) has its third input node (set) coupled to a node of application of the external switch control signal (CMD_{EXT}); and
- the first D flip-flop (911) has its second input node (ck) coupled to the output of the comparator (903) and the second D flip-flop (913) has its second input node (ck) coupled to the output of the comparator (903) via an inverter.

14. The conversion circuit (500) of claim 13, wherein, for each first switch (Si), the second circuit (803) of the control circuit comprises an AND gate (915) having a first input coupled to the output node (q) of the first D flip-flop (911), a second input coupled to the output node (q) of the second D flip-flop (913), and an output coupled to a node for supplying the logic output signal of the second circuit (803).

15. The conversion circuit (500) of any of claims 1 to 14, wherein the first switches (S1, S2, S3, S4) are gallium nitride switches.
